# EUROPEAN PATENT APPLICATION

(11) **EP 1 939 244 A2**
(43) Date of publication of application: **02.07.2008**
(21) Application number: 07024717.6
(22) Date of filing: 20.12.2007
(51) Int. Cl.: C08K 3/04, C08K 7/24

(54) **Laser-decomposable resin composition, and pattern-forming material and laser-engravable flexographic printing plate precursor using the same**

(30) Priority: 27.12.2006 JP 2006351430
(71) Applicant: FUJIFILM Corporation, Minato-ku Tokyo (JP)
(72) Inventor: Sugasaki, Atsushi c/o Fujifilm Corporation, Haibara-gun Shizuoka (JP)
(74) Representative: HOFFMANN EITLE

(57) **Abstract**

A laser-decomposable resin composition includes (A) at least one selected from the group consisting of a carbon nanotube and a fullerene; and (B) a binder polymer.

## Description

### Background of the Invention

### 1. Field of the Invention

The present invention relates to a laser-decomposable resin composition, more specifically, a laser-decomposable resin composition having high decomposability for laser processing, and a pattern-forming material and a laser-engravable flexographic printing plate precursor using the composition.

### 2. Description of the Related Art

The decomposable resin and decomposable resin composition are a material such that the resin decomposes in response to an external factor such as thermal factor, mechanical factor, photochemical factor, radiation chemical factor and chemical factor, and are widely known. Changes caused by decomposition of the resin, that is, changes in the form (liquefaction, vaporization) between before and after decomposition of the resin or composition, and changes in the nature or property such as molecular weight, hardness, viscoelasticity, glass transition temperature (Tg), solubility and adhesive property, are utilized and these resins or compositions are being used in various fields.

Examples of the decomposable resin and decomposable resin composition include a biodegradable plastic (e.g., polylactic acid) for decreasing the environmental effect of plastic materials, and a sustained-release material for gradually releasing a preparation, a fragrance or the like, which is used, for example, in the fields of medical treatments, cosmetics and life science. These are, however, a material which gradually decomposes in oxygen, light, enzyme, living body, soil or the like under a natural environment, but are not a material which stably maintains the initial state and abruptly brings about a great change in the nature by the effect of external stimulation.

In order to impart a recycling property or simplify the waste treatment, there have been developed, for example, a resin which decomposes, or an adhesive which decreases in the adhesive property, by the effect of light or heat. It is also known to form a porous material by mixing a decomposable resin with ceramic, carbon fiber or the like and removing the decomposable resin through firing. However, these are a technique of treating and processing the material as a whole but not a technique of forming a necessary pattern only in a necessary portion. Furthermore, the decomposition treatment requires a large energy.

As for utilization in the image formation, there is known, for example, a technique of satisfying both storage stability as a toner and image fixing property by using a toner containing a thermally decomposable resin and utilizing changes in the nature due to heat at the fixing under heating. Here, however, the resin itself is not satisfactorily responsive to pattern-like stimulation.

As regards the pattern-forming material, for example, a photoresist of which pattern formation is performed by subjecting a composition containing a photoacid generator and an acid-decomposable resin to pattern-like exposure and, if desired, heat treatment to cause pattern-like decomposition of the resin and developing the resist film, is widely known as a so-called chemical amplification-type resist. Both storage stability and pattern-forming property of this composition are satisfied in a practical level, but a development process under satisfactorily controlled processing conditions are indispensable for the pattern formation and although applicable to a thin film, this composition can be hardly applied to pattern formation of a thick film, for example, in several tens of µm or more.

Furthermore, a method of forming an image by utilizing a step of imagewise irradiating laser light to partially remove (ablate) a thin film is known (see, JP-A-10-119436 (the term "JP-A" as used herein means an "unexamined published Japanese patent application")). However, examples described for the compound employed as a thermally decomposable resin are merely a normal general-purpose resin such as polyester, polycarbonate and polyurethane, and the film thickness is approximately from 1 to 2 µm at most. There is also known a case using a compound of which thermal decomposability is specified (see, JP-A-10-244751). However, even in this case, the film thickness is approximately from 1 to 2 µm at most.

As regards the mask material for use in paste printing or the like on a printed wiring board, a mask for forming a pattern in approximately from 100 to 200 µm by utilizing a photodecomposable sheet, and a production method thereof are disclosed (see, JP-A-8-258442). However, this patent publication is silent on specific compounds, and a controlled development processing is indispensable for forming a pattern by adjusting the degree of exposure and development.

On the other hand, as regards the technique of forming a pattern in a thick film by a simple processing, for example, pattern formation by laser processing is known, where a substrate itself is removed, deformed or discolored by imagewise irradiating laser light. For example, a laser marker is utilized for entering information such as lot number in products (e.g., videotape, home electric appliance) comprising various substrates. In this case, however, a normal resin or the like is directly used as the substrate itself.

In the pattern formation by laser processing, it is demanded that a laser-engraved part (trough) is swiftly formed. For this purpose, a laser-engravable pattern-forming material having high sensitivity is necessary.

Particularly, in the case of a flexographic printing plate precursor of laser direct-drawing type (a so-called flexographic printing plate for laser engraving), easy engravability by laser light (engraving sensitivity) governs the plate-making speed and therefore, a laser-engravable flexographic printing plate using a laser-decomposable resin composition having high sensitivity is demanded.

JP-A-2004-160898 and JP-A-2002-244289 disclose pattern formation by laser processing for forming a pattern in a thick film by a simple processing, but in these patent publications, addition of a carbon nanotube or a fullerene of the present invention described later is not suggested by any means, though use of carbon black or graphite as an additive is described.

### Summary of the Invention

The present invention provides a laser-decomposable resin composition which is applicable also to a thick film, exhibits high engraving sensitivity and enables efficient engraving with a low laser energy, and a pattern-forming material and a laser-engravable flexographic printing plate precursor, each using the composition.

As a result of many intensive studies, the present inventors have found that addition of a carbon nanotube or a fullerene to the composition enables easy decomposition of a binder polymer which is usually not decomposed with ease by heating or laser exposure, and this property can be made use of to more facilitate the pattern formation by laser exposure than ever before.

That is, the above-described object can be attained by the following constructions.
(1) A laser-decomposable resin composition comprising:
   (A) at least one selected from the group consisting of a carbon nanotube and a fullerene; and
   (B) a binder polymer.
(2) The laser-decomposable resin composition as described in (1), wherein
   the component (A) is a carbon nanotube.
(3) The laser-decomposable resin composition as described in (2), wherein
   the carbon nanotube is a carbon nanotube subjected to at least one of chemical modification and physical modification.
(4) The laser-decomposable resin composition as described in (2), wherein
   the carbon nanotube is a carbon nanotube subjected to ultrasonic irradiation.
(5) The laser-decomposable resin composition as described in (2), wherein
   the carbon nanotube has a length of from 20 nm to 10 µm.
(6) The laser-decomposable resin composition as described in (2), wherein
   the carbon nanotube is a carbon nanotube physically modified by interaction with a polymer different from the component (B).
(7) The laser-decomposable resin composition as described in (6), wherein
   the polymer different from the component (B) is a polysaccharide.
(8) The laser-decomposable resin composition as described in (1), wherein
   the component (A) is an unmodified fullerene.
(9) The laser-decomposable resin composition as described in (1), further comprising:
   (C) a polymerizable compound.
(10) A laser-decomposable resin composition obtained by curing the laser-decomposable resin composition as described in (1).
(11) A pattern-forming material comprising:
   a layer that comprises the laser-decomposable resin composition as described in (1).
(12) A laser-engravable flexographic printing plate precursor comprising:
   the pattern-forming material as described in (11).
      The pattern-forming material having a layer comprising a laser-decomposable resin composition, as used in the present invention, indicates materials in general where the laser exposed area becomes a trough of a corrugated pattern. A trough may be formed by applying a heating treatment or a development processing with an aqueous alkali solution or the like after laser exposure, but the pattern-forming material of the present invention is suitably used particularly when a trough is formed directly by laser exposure (by means of ablation).
      The operation mechanism in the present invention is not clearly known but is presumed as follows.
      The carbon nanotube or fullerene for use in the present invention generates heat upon laser irradiation and this heat generated in surplus assists in the thermal
   decomposition of a binder polymer present together.
   In a preferred embodiment, the carbon nanotube is chemically modified or physically modified, whereby good dispersibility in a solvent or a binder polymer is achieved, as a result, the heat generation efficiency and in turn, the laser decomposition sensitivity can be enhanced.
   Also, in a preferred embodiment, (C) a polymerizable compound is used in combination, whereby film physical properties can be adjusted (for example, brittleness or flexibility can be adjusted by the amount of the polymerizable compound).
   Furthermore, from the standpoint of enhancing the film strength, it is preferred that the composition of the present invention is previously changed into a crosslinked (polymerized) composition before laser decomposion.

### Detailed Description of the Invention

The laser-decomposable resin composition of the present invention at least comprises (A) at least one member selected from carbon nanotubes and fullerenes, and (B) a binder polymer.
The components contained in the laser-decomposable resin composition are described in detail below.

### (A) At least one member selected from carbon nanotubes and fullerenes

As for the carbon nanotube or fullerene in the component (A), a known material may be used. For example, those described in Hisanori Shinohara (compiler), Nanocarbon no Shin-Tenkai (New Development of Nanocarbon), Kagaku Dojin (2005) can be used. In particular, as regards the carbon nanotube, various types described in R. Saito et al., Physical Properties of Carbon Nanotubes, Imperial College (1998) can be appropriately used. As regards the fullerene, various types described in the Chemical Society of Japan (compiler), "Tanso Daisan no Dosotai Fullerene no Kagaku (Chemistry of Third Carbon Allotrope Fullerene)" of Kikan Kagaku Sosetsu (Quarterly Chemical Review), No. 43, Japan Scientific Societies Press (1999), and Hisanori Shinohara et al., Fullerene no Kagaku to Butsuri (Chemistry and Physics of Fullerene), The University of Nagoya Press (1997), can be appropriately used.

Specific examples thereof include carbon nanotubes such as single-wall carbon nanotube and multi-wall carbon nanotube, and fullerenes such as fullerene C60, fullerene C70, fullerene C76, fullerene C78 and fullerene C82. Among these, fullerene C60, fullerene C70 and a multi-wall carbon nanotube are preferred. A derivative obtained by hydrogenation, oxidation, alkylation, amination, halogenation, cyclization addition, or clathration of fullerene may also be used. Furthermore, a fullerene subjected to an organic treatment with a coupling agent or the like may also be used.

From the standpoint of obtaining good laser decomposition sensitivity, the component (A) is preferably a carbon nanotube.

The carbon nanotube in general has bad dispersibility in a medium such as water or organic solvent and therefore, even when dispersed in a binder polymer solution, the carbon nanotube readily aggregates, as a result, the carbon nanotube will be present in an aggregated state in the binder polymer film formed by removing the solvent. The carbon nanotube aggregate diffuses the heat generated upon laser irradiation, and the heat which should be used for the decomposition of the binder polymer may run short. Accordingly, irrespective of whether chemical or physical modification is applied, from the standpoint of maintaining the dispersibility in a solvent or a binder polymer, the carbon nanotube is preferably subjected to the following cutting treatment to have a length of from 5 nm to 100 µm, more preferably from 10 nm to 50 µm, still more preferably from 20 nm to 10 µm.

The cutting treatment is known and described in M. Sano et al., Science, 293, 1299 (2001) and M. Sano et al., Angew. Chem. Int. Ed., 40, 4611 (2001). Although detailed determination of the structure of carbon nanotube subjected to the cutting treatment is unclear, by virtue of introduction of a carboxyl group or a phenol group into the cutting site, dispersibility in water or an organic solvent is enhanced and therefore, this treatment is preferably used also in the present invention.

Furthermore, when the carbon nanotube is irradiated with an ultrasonic wave, its dispersibility in a solvent or a binder polymer is enhanced. Accordingly, a process of irradiating an ultrasonic wave on the carbon nanotube is preferably performed at the preparation of the composition.

For more aggressively enhancing the dispersibility of the carbon nanotube, it is preferred to chemically modify and/or physically modify the carbon nanotube. By virtue of enhanced dispersibility, an effect of reducing the sensitivity unevenness (a phenomenon that the high-concentration portion resulting from aggregation of the carbon nanotube is highly sensitive as compared with the unaggregated portion and the depth of corrugated pattern differs depending on the position of an image) can also be confirmed.

The chemical modification as used herein means to introduce a functional group into the carbon nanotube surface through a covalent bond by a chemical reaction. The chemical modification method and chemically modified carbon nanotube are known and disclosed in the above-described literatures (Hisanori Shinohara (compiler), Nanocarbon no Shin-Tenkai (New Development of Nanocarbon), Kagaku Dojin (2005), R. Saito et al., Physical Properties of Carbon Nanotubes, Imperial College (1998), the Chemical Society of Japan (compiler), "Tanso Daisan no Dosotai Fullerene no Kagaku (Chemistry of Third Carbon Allotrope Fullerene)" of Kikan Kagaku Sosetsu (Quarterly Chemical Review), No. 43, Japan Scientific Societies Press (1999), and Hisanori Shinohara et al., Fullerene no Kagaku to Butsuri (Chemistry and Physics of Fullerene), The University of Nagoya Press (1997)). The functional group introduced is preferably an amino group, a carboxyl group, a sulfonic acid group, a phosphoric acid group, an amide group or the like.

The physical modification means that an organic molecule is bonded to the carbon nanotube surface by a noncovalent bond. Here, the noncovalent bond formed between the organic molecule and the carbon nanotube indicates mainly a bond derived from a gravitational interaction through a hydrophobic interaction or a van der Waals interaction. Above all, an embodiment of effecting the physical modification by an interaction with a polymer different from the following binder polymer (B) is preferred, and an embodiment of physically modifying the carbon nanotube with a polysaccharide is more preferred. Such physical modification is disclosed in M. Numata et al., J. Am. Chem. Soc., 127, 5875 (2005) and can be easily performed. The physically modified carbon nanotube is assured particularly of good dispersibility and is enhanced particularly in the laser decomposition sensitivity. By virtue of this high dispersibility, the above-described aggregation of carbon nanotubes with each other can be suppressed and the laser decomposition sensitivity can be prevented from reduction ascribable to heat diffusion caused by the aggregation.

Examples of the polysaccharide include curdlan, schizophyllan, amylose, carrageenan, mannan, carboxymethyl cellulose, alginic acid, lentinan, laminaran, agarose, succinoglucan, gellan gum and galactomannan. In view of easy physical modification of the carbon nanotube, curdlan, schizophyllan, carrageenan, alginic acid and agarose are preferred, curdlan and schizophyllan are more preferred, and curdlan reduced in the molecular weight by a hydrolysis treatment is most preferred. The molecular weight of the curdlan is, in terms of the weight average molecular weight, preferably from 10,000 to 500,000, more preferably from 20,000 to 300,000, still more preferably from 30,000 to 200,000. Incidentally, the weight average molecular weight as used in the present invention means a value measured by GPC (gel permeation chromatography).

From the standpoint that the carbon nanotube can be easily and satisfactorily fine-dispersed in a film, the amount of physical modification with the polysaccharide is equal to or greater than the weight of carbon nanotube (from 1.0 to 50 times in terms of weight), preferably from 1.0 to 30 times, more preferably from 1.0 to 10 times.

In addition, a carbon nanotube physically modified with polyvinylpyrrolidone is also suitable. Enhancement of dispersibility and enhancement of laser decomposition sensitivity can be confirmed also when a carbon nanotube physically modified with polyvinylpyrrolidone is used.

As for the fullerene used in the present invention, in view of easy availability, among those described above, fullerene C60, fullerene C70 and chemically modified products thereof are preferred, and unmodified C60 is more preferred.

One of these components (A) for use in the present invention may be used alone, or two or more species thereof may be used in combination. The amount of the component (A) added is, in view of maintaining good dispersibility in a solvent or a binder polymer, preferably from 0.01 to 50 mass%, more preferably from 0.1 to 30 mass%, still more preferably from 1.0 to 20 mass%, based on the entire solid content of the composition.

### (B) Binder polymer

The binder polymer contained in the laser-decomposable resin composition of the present invention is preferably a binder polymer having a carbon-carbon unsaturated bond at least in either the main chain or the side chain. A polymer containing at least either an olefin (carbon-carbon double bond) or a carbon-carbon triple bond in the main chain is more preferred in that the mechanical strength of the film formed is high, and a polymer containing an olefin in the main chain is still more preferred.

Examples of the polymer containing at least either an olefin or a carbon-carbon triple bond in the main chain include SB (polystyrene-polybutadiene), SBS (polystyrene-polybutadiene-polystyrene), SIS (polystyrene-polyisoprene-polystyrene) and SEBS (polystyrene-polyethylene/polybutylene-polystyrene).

In the case where a polymer having a highly reactive polymerizable unsaturated group such as methacryloyl group is used as the polymer having a carbon-carbon unsaturated bond in the side chain, a film assured of very high mechanical strength can be formed. In particular, a polyurethane-based or polyester-based thermoplastic elastomer enables relatively easy introduction of a highly reactive polymerizable unsaturated group into the molecule. The term "into the molecule" as used herein includes a case where a polymerizable unsaturated group is directly attached at both terminals or one terminal of the polymer main chain, at the terminal of the polymer side chain, or in the polymer main chain or side chain. A polymer where a polymerizable unsaturated group is directly introduced into the molecular terminal may be used, but there may be suitably used another method, for example, a method of reacting a compound having a plurality of reactive groups such as hydroxyl group, amino group, epoxy group, carboxyl group, acid anhydride group, ketone group, hydrazine residue, isocyanate group, isothiocyanate group, cyclic carbonate group and ester group and having a molecular weight of about several thousands, with a binder having a plurality of groups bondable to those reactive groups (for example, polyisocyanate when the reactive group is a hydroxyl group or an amino group), and after adjustment of the molecular weight and conversion to the terminal bonding group, reacting the resulting compound with an organic compound having a polymerizable unsaturated group and a group capable of reacting with the terminal bonding group, thereby introducing a polymerizable unsaturated group into the terminal.

The binder polymer contained in the laser-decomposable resin composition of the present invention is preferably the above-described polymer having a carbon-carbon unsaturated bond but may be even a polymer not having a carbon-carbon unsaturated bond. Examples of the polymer not having a carbon-carbon unsaturated bond include a resin which can be easily synthesized by adding hydrogen to the olefin moiety of the above-described polymer having a carbon-carbon unsaturated bond or by forming a polymer from a raw material previously subjected to hydrogenation of its olefin moiety (for example, a compound obtained by hydrogenation of butadiene or isoprene).

The number average molecular weight of the binder polymer is preferably from 1,000 to 1,000,000, more preferably from 5,000 to 500,000. When the number average molecular weight is from 1,000 to 1,000,000, mechanical strength of the film formed can be ensured. The number average molecular weight is a value measured by gel permeation chromatography (GPC) and evaluated with respect to a polystyrene preparation of which molecular weight is known.

The total amount of resins in the decomposable resin composition of the present invention is generally from 1 to 99 mass%, preferably from 5 to 80 mass%.

Incidentally, the polymer having a carbon-carbon unsaturated bond and the following general resin may be used in combination.

The amount added of the resin used in combination is generally from 1 to 90 mass%, preferably from 5 to 80 mass%, based on the polymer having a carbon-carbon unsaturated bond.

The resin used in combination may be an elastomer or a non-elastomer.

The number average molecular weight of the resin used in combination is preferably from 1,000 to 1,000,000, more preferably from 5,000 to 500,000. When the number average molecular weight is from 1,000 to 1,000,000, mechanical strength of the film formed can be ensured. The number average molecular weight is a value measured by gel permeation chromatography (GPC) and evaluated with respect to a polystyrene preparation of which molecular weight is known.

The resin is preferably a readily liquefiable resin or a readily decomposable resin. The readily decomposable resin preferably contains in its molecular chain a readily decomposable monomer unit such as styrene, α-methylstyrene, α-methoxystyrene, acryl esters, methacryl esters, ester compounds, ether compounds, nitro compounds, carbonate compounds, carbamoyl compounds, hemiacetal ester compounds, oxyethylene compounds and aliphatic cyclic compounds. In particular, representative examples of the readily decomposable resin are polyethers such as polyethylene glycol, polypropylene glycol and polytetraethylene glycol, aliphatic polycarbonates, aliphatic polycarbamates, and polymers having a molecular structure such as polymethyl methacrylate, polystyrene, nitrocellulose, polyoxyethylene, polynorbornene, hydrated polycyclohexadiene and dendrimer with many branched structures. Also, a polymer containing many oxygen atoms in the molecular chain is preferred in view of decomposability. Out of these, a compound having a carbonate group, a carbamate group or a methacryl group in the polymer main chain is preferred because of high thermal decomposability. For example, a polyester or polyurethane synthesized starting from (poly)carbonate diol or (poly)carbonate dicarboxylic acid, and a polyamide synthesized starting from (poly)carbonate diamine, are a polymer assured of good thermal decomposability. These polymers may contain a polymerizable unsaturated group in the main chain or side chain thereof. Particularly, in the case of having a reactive functional group such as hydroxy group, amino group and carboxyl group, a polymerizable unsaturated group can be easily introduced.

The thermoplastic elastomer is not particularly limited, but examples thereof include a urethane-based thermoplastic elastomer, an ester-based thermoplastic elastomer, an amide-based thermoplastic elastomer and a silicone-based thermoplastic elastomer. In order to more enhance the thermal decomposability, there may be also used a polymer where an easily decomposable functional group having high decomposability, such as carbamoyl group and carbonate group, is introduced into the main chain. The polymer may be mixed with a polymer having higher thermal decomposability. The thermoplastic elastomer is fluidized when heated and therefore, can be successfully mixed with a composite for use in the present invention. The thermoplastic elastomer is a material which is fluidized when heated and can be shaped similarly to a normal thermoplastic plastic and which exhibits rubber elasticity at ordinary temperature. The molecular structure comprises a soft segment like a polyether or rubber molecule, and a hard segment which prevents plastic deformation around ordinary temperature similarly to vulcanized rubber. As for the hard segment, there are present various types such as frozen phase, crystalline phase, hydrogen bond and ionic crosslinking.

The kind of the thermoplastic elastomer can be selected according to usage of the resin composition. For example, urethane-based, ester-based, amide-based and fluorine-based thermoplastic elastomers are preferred in the field requiring solvent resistance, and urethane-based, olefin-based, ester-based and fluorine-based thermoplastic elastomers are preferred in the field requiring heat resistance. Also, the hardness can be greatly varied by the kind of the thermoplastic elastomer.

The non-elastomeric thermoplastic resin is not particularly limited, but examples thereof include a polyester resin, an unsaturated polyester resin, a polyamide resin, a polyamideimide resin, a polyurethane resin, an unsaturated polyurethane resin, a polysulfone resin, a polyethersulfone resin, a polyimide resin, a polycarbonate resin and a wholly aromatic polyester resin.

The resin used in combination may be a hydrophilic polymer. The hydrophilic polymer includes, for example, a hydrophilic polymer containing hydroxyethylene as a constituent unit. Specific examples thereof include a polyvinyl alcohol, a vinyl alcohol/vinyl acetate copolymer (partially saponified polyvinyl alcohol), and modified products thereof. As for the hydrophilic polymer, a single polymer may be used or a plurality of species may be mixed and used. Examples of the modified product include a polymer obtained by modifying at least a part of the hydroxyl groups into a carboxyl group, a polymer obtained by modifying a part of the hydroxyl groups into a (meth)acroyl group, a polymer obtained by modifying at least a part of the hydroxyl groups into an amino group, and a polymer obtained by introducing ethylene glycol, propylene glycol or a dimer thereof into the side chain.

The polymer obtained by modifying at least a part of the hydroxyl groups into a carboxyl group can be produced by esterifying a polyvinyl alcohol or partially saponified polyvinyl alcohol with a polyfunctional carboxylic acid such as succinic acid, maleic acid and adipic acid.

The polymer obtained by modifying at least a part of the hydroxyl groups into a (meth)acroyl group can be produced by adding a glycidyl group-containing ethylenically unsaturated monomer to the above-described carboxyl group-modified polymer or by esterifying a polyvinyl alcohol or partially saponified polyvinyl alcohol with a (meth)acrylic acid.

The polymer obtained by modifying at least a part of the hydroxyl groups into an amino group can be produced by esterifying a polyvinyl alcohol or partially saponified polyvinyl alcohol with an amino group-containing carboxylic acid such as carbamic acid.

The polymer obtained by introducing ethylene glycol, propylene glycol or a dimer thereof into the side chain can be produced by heating a polyvinyl alcohol or partially saponified polyvinyl alcohol and glycols in the presence of a sulfuric acid catalyst, and removing the by-product water out of the reaction system.

Among these polymers, a polymer obtained by modifying at least a part of the hydroxyl groups into a (meth)acroyl group is preferred. Because, by virtue of direct introduction of an unreacted crosslinking functional group into the polymer component, the film formed can be increased in the strength and both flexibility and strength of the film formed can be satisfied.

The weight average molecular weight (in terms of polystyrene by GPC measurement) of the hydrophilic polymer is preferably from 10,000 to 500,000. When the weight average molecular weight is 10,000 or more, the shape retentivity as a simple resin is excellent, and when it is 500,000 or less, the polymer readily dissolves in a solvent such as water and this is advantageous in preparing a crosslinking resin composition.

The resin used in combination may also be a solvent-soluble resin. Specific examples thereof include a polysulfone resin, a polyethersulfone resin, an epoxy resin, an alkyd resin, a polyolefin resin and a polyester resin.

The resin used in combination usually has no highly reactive polymerizable unsaturated group but may have a highly reactive polymerizable unsaturated group at the terminal of the molecular chain or in the side chain. In the case of using a polymer having a highly reactive polymerizable unsaturated group such as methacryloyl group, a film assured of very high mechanical strength can be produced. In particular, a polyurethane-based or polyester-based thermoplastic elastomer enables relatively easy introduction of a highly reactive polymerizable unsaturated group into the molecule. The term "into the molecule" as used herein includes a case where a polymerizable unsaturated group is directly attached at both terminals or one terminal of the polymer main chain, at the terminal of the polymer side chain, or in the polymer main chain or side chain. A polymer where a polymerizable unsaturated group is directly introduced into the molecular terminal may be used, but there may be suitably used another method, for example, a method of reacting a compound having a plurality of reactive groups such as hydroxyl group, amino group, epoxy group, carboxyl group, acid anhydride group, ketone group, hydrazine residue, isocyanate group, isothiocyanate group, cyclic carbonate group and ester group and having a molecular weight of about several thousands, with a binder having a plurality of groups bondable to those reactive groups (for example, polyisocyanate when the reactive group is a hydroxyl group or an amino group), and after adjustment of the molecular weight and conversion to the terminal bonding group, reacting the resulting compound with an organic compound having a polymerizable unsaturated group and a group capable of reacting with the terminal bonding group, thereby introducing a polymerizable unsaturated group into the terminal.

In addition to these components (A) and (B), the laser-decomposable resin composition of the present invention may contain a polymerizable compound (monomer), an initiator and, if desired, other various components. The polymerizable compound (monomer), initiator and other components are described below.

### (C) Polymerizable compound (monomer)

This is described in detail below by referring to a case using an addition-polymerizable group as the polymerizable compound (monomer).

### <Addition-Polymerizable Compound>

The addition-polymerizable compound having at least one ethylenically unsaturated double bond, which is a preferred polymerizable compound for use in the present invention, is selected from compounds having at least one, preferably two or more, ethylenically unsaturated bond(s). Such compounds are widely known in this industrial field and these known compounds can be used in the present invention without any particular limitation. These compounds have a chemical mode such as monomer, prepolymer (that is, dimer, trimer or oligomer) or a mixture thereof. Examples of the monomer include an unsaturated carboxylic acid (e.g., acrylic acid, methacrylic acid, itaconic acid, crotonic acid, isocrotonic acid, maleic acid), and esters and amides thereof. Among these, preferred are esters of an unsaturated carboxylic acid with an aliphatic polyhydric alcohol compound, and amides of an unsaturated carboxylic acid with an aliphatic polyvalent amine compound. Also, an addition reaction product of an unsaturated carboxylic acid ester or amide having a nucleophilic substituent such as hydroxyl group, amino group or mercapto group with a monofunctional or polyfunctional isocyanate or epoxy, and a dehydrating condensation reaction product with a monofunctional or polyfunctional carboxylic acid may be suitably used. Furthermore, an addition reaction product of an unsaturated carboxylic acid ester or amide having an electrophilic substituent such as isocyanate group or epoxy group with a monofunctional or polyfunctional alcohol, amine or thiol, and a displacement reaction product of an unsaturated carboxylic acid ester or amide having a desorptive substituent such as halogen group or tosyloxy group with a monofunctional or polyfunctional alcohol, amine or thiol may also be suitably used. In addition, compounds where the unsaturated carboxylic acid of the above-described compounds is replaced by an unsaturated phosphonic acid, styrene, vinyl ether or the like, may also be used.

Specific examples of the ester monomer of an aliphatic polyhydric alcohol compound with an unsaturated carboxylic acid include the followings. Examples of the acrylic acid ester include ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl)isocyanurate and polyester acrylate oligomer.

Examples of the methacrylic acid ester include tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy)-phenyl]dimethylmethane and bis[p-(methacryloxyethoxy)phenyl]dimethylmethane.

Examples of the itaconic acid ester include ethylene glycol diitaconate, propylene glycol diitaconate, 1,3-butanediol diitaconate, 1,4-butanediol diitaconate, tetramethylene glycol diitaconate, pentaerythritol diitaconate and sorbitol tetraitaconate.

Examples of the crotonic acid ester include ethylene glycol dicrotonate, tetramethylene glycol dicrotonate, pentaerythritol dicrotonate and sorbitol tetradicrotonate.

Examples of the isocrotonic acid ester include ethylene glycol diisocrotonate, pentaerythritol diisocrotonate and sorbitol tetraisocrotonate.

Examples of the maleic acid ester include ethylene glycol dimaleate, triethylene glycol dimaleate, pentaerythritol dimaleate and sorbitol tetramaleate.

Other examples of the ester which can be suitably used include aliphatic alcohol-based esters described in JP-B-46-27926 (the term "JP-B" as used herein means an "examined Japanese patent publication"), JP-B-51-47334 and JP-A-57-196231, those having an aromatic skeleton described in JP-A-59-5240, JP-A-59-5241 and JP-A-2-226149, and those containing an amino group described in JP-A-1-165613.

These ester monomers may also be used as a mixture.

Specific examples of the amide monomer of an aliphatic polyvalent amine compound with an unsaturated carboxylic acid include methylenebisacrylamide, methylenebismethacrylamide, 1,6-hexamethylenebisacrylamide, 1,6-hexamethylenebismethacrylamide, diethylenetriaminetrisacrylamide, xylylenebisacrylamide and xylylenebismethacrylamide.
Other preferred examples of the amide-based monomer include those having a cyclohexylene structure described in JP-B-54-21726.
A urethane-based addition-polymerizable compound produced using an addition reaction of an isocyanate with a hydroxyl group is also suitably used, and specific examples thereof include a vinyl urethane compound having two or more polymerizable vinyl groups within one molecule described in JP-B-48-41708, which is obtained by adding a vinyl monomer having a hydroxyl group represented by the following formula (V) to a polyisocyanate compound having two or more isocyanate groups within one molecule.

CH₂=C(R)COOCH₂CH(R')OH (V)

(wherein R and R' each represents H or CH₃).

In addition, urethane acrylates described in JP-A-51-37193, JP-B-2-32293 and JP-B-2-16765, and urethane compounds having an ethylene oxide-based skeleton described in JP-B-58-49860, JP-B-56-17654, JP-B-62-39417 and JP-B-62-39418 are also suitably used.

Furthermore, when addition-polymerizable compounds having an amino or sulfide structure within the molecule described in JP-A-63-277653, JP-A-63-260909 and JP-A-1-105238 are used, a cured composition can be obtained in a short time.

Other examples include a polyfunctional acrylate or methacrylate such as polyester acrylates described in JP-A-48-64183, JP-B-49-43191 and JP-B-52-30490 and epoxy acrylates obtained by reacting an epoxy resin with a (meth)acrylic acid. Also, a specific unsaturated compound described in JP-B-46-43946, JP-B-1-40337 and JP-B-1-40336, a vinyl phosphonic acid-based compound described in JP-A-2-25493, or the like may be used. In some cases, a structure containing a perfluoroalkyl group described in JP-A-61-22048 is suitably used. Furthermore, those described as a photocurable monomer or oligomer in Adhesion, Vol. 20, No. 7, pp. 300-308 (1984) may also be used.

In view of photosensitive speed, a structure having a large unsaturated group content per one molecule is preferred and in most cases, a bifunctional or greater functional compound is preferred. For increasing the strength of the image area, namely, the cured layer, a trifunctional or greater functional compound is preferred. Also, a method of controlling both photosensitivity and strength by using a combination of compounds differing in the functional number or differing in the polymerizable group (for example, an acrylic acid ester, a methacrylic acid ester, a styrene-based compound and a vinyl ether-based compound) is effective. The addition-polymerizable compound is preferably used in an amount of 5 to 80 mass%, more preferably from 25 to 75 mass%, based on the entire solid content in the composition. Also, one of these compounds may be used alone, or two or more thereof may be used in combination.

Before and/or after laser decomposition, the laser-decomposable resin composition containing the polymerizable compound can be polymerized and cured by an energy such as light and heat.

### <Initiator>

As for the initiator, those known to one skilled in the art can be used without limitation. Specific known examples thereof include many compounds described in Bruce M. Monroe et al., Chemical Revue, 93, 435 (1993); R.S. Davidson, Journal of Photochemistry and Biology A: Chemistry, 73, 81 (1993); J.P. Faussier, "Photoinitiated Polymerization-Theory and Applications" of Rapra Review, Vol. 9, Report, Rapra Technology (1998); and M. Tsunooka et al., Prog. Polym. Sci., 21, 1 (1996). There are also known a group of compounds which undergo oxidative or reductive bond cleavage, such as those described in F.D. Saeva, Topics in Current Chemistry, 156, 59 (1990); G.G. Maslak, Topics in Current Chemistry, 168, 1 (1993); H.B. Shuster et al., JACS, 112, 6329 (1990); and I.D.F. Eaton et al., JACS, 102, 3298 (1980).

In regard to specific preferred examples of the initiator, a radical initiator which is a compound capable of generating a radical by an energy of light and/or heat and initiating or accelerating a polymerization reaction of the binder polymer or a polymerizable compound such as the above-described polymerizable compound (C) is described below, but the present invention is not limited thereto.

Preferred examples of the radical initiator for use in the present invention include (a) aromatic ketones, (b) onium salt compounds, (c) organic peroxides, (d) thio compounds, (e) hexaarylbiimidazole compounds, (f) ketooxime ester compounds, (g) borate compounds, (h) azinium compounds, (i) metallocene compounds, (j) active ester compounds, (k) compounds having a carbon-halogen bond, and (1) azo-based compounds. Specific examples of the compounds (a) to (1) are set forth below, but the present invention is not limited thereto.

### (a) Aromatic Ketones

The (a) aromatic ketones preferred as the radical initiator for use in the present invention include compounds having a benzophenone skeleton or a thioxanthone skeleton described in J.P. Fouassier and J.F. Rabek, Radiation Curing in Polymer Science and Technology, pp. 77-117 (1993). Examples thereof include the compounds shown below.

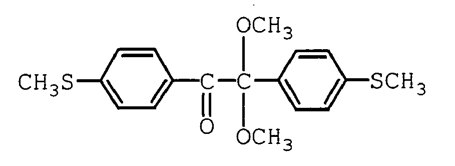

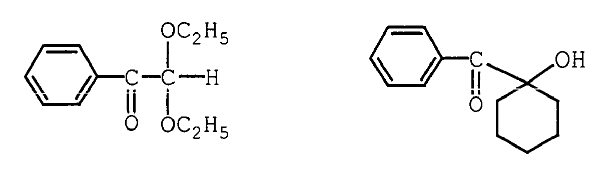

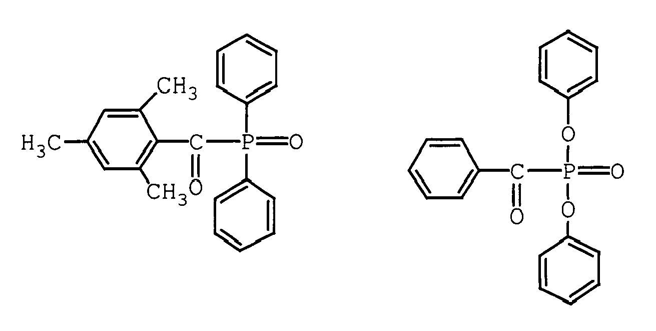

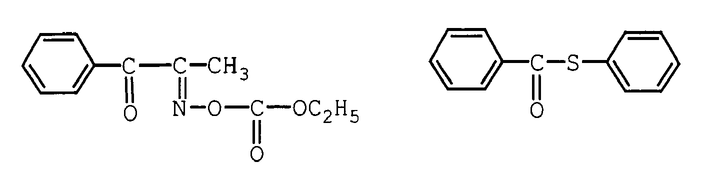

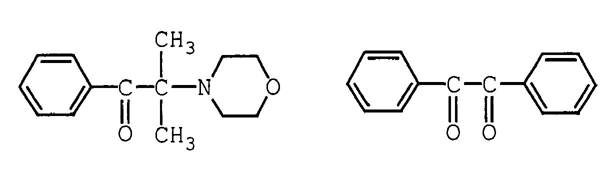

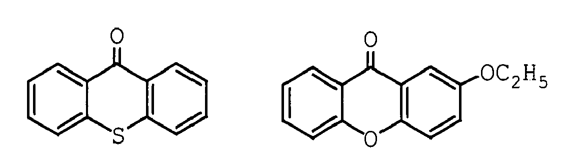

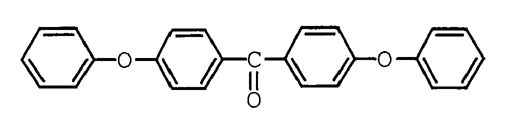

Among (a) the aromatic ketones, the following compounds are preferred.

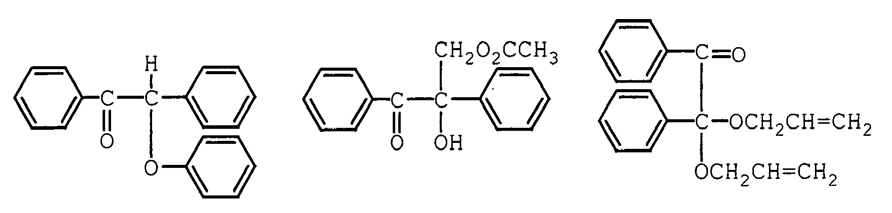

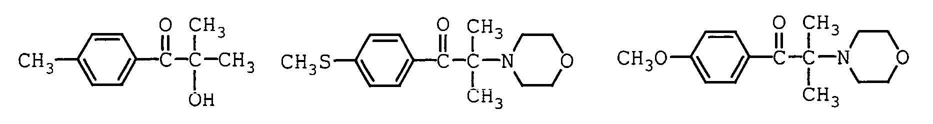

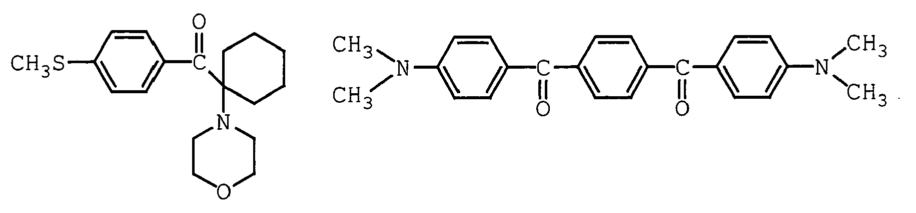

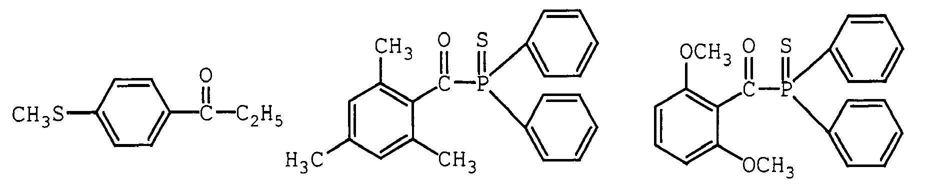

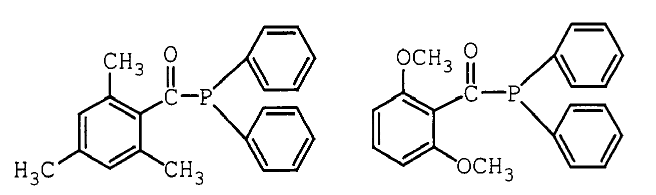

### (b) Onium Salt Compound

The (b) onium salt compound preferred as the radical initiator for use in the present invention includes compounds represented by the following formulae (1) to (3).

Formula (1):

Ar¹-I⁺-Ar² (Z²)⁻

Formula (2):

Ar³-N⁺≡N (Z³)⁻

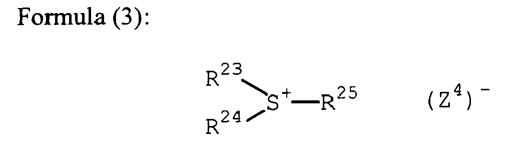

In formula (1), Ar¹ and Ar² each independently represents an aryl group having a carbon number of 20 or less, which may have a substituent. (Z²)⁻ represents a counter ion selected from the group consisting of a halogen ion, a perchlorate ion, a carboxylate ion, a tetrafluoroborate ion, a hexafluorophosphate ion and a sulfonate ion, and is preferably a perchlorate ion, a hexafluorophosphate ion or an arylsulfonate ion.

In formula (2), Ar³ represents an aryl group having a carbon number of 20 or less, which may have a substituent. (Z³)⁻ represents a counter ion having the same meaning as (Z²)⁻.

In formula (3), R²³, R²⁴ and R²⁵ may be the same or different and each represents a hydrocarbon group having a carbon number of 20 or less, which may have a substituent. (Z⁴)⁻ represents a counter ion having the same meaning as (Z²)⁻.

Specific examples of the onium salt which can be suitably used in the present invention include those described in JP-A-2001-133969 (paragraphs [0030] to [0033]) and JP-A-2001-343742 (paragraphs [0015] to [0046]), which have been previously proposed by the present applicant, and specific aromatic sulfonium salt compounds described in JP-A-2002-148790, JP-A-2001-343742, JP-A-2002-6482, JP-A-2002-116539 and JP-A-2004-102031.

### (c) Organic Peroxide

The (c) organic peroxide preferred as the radical initiator for use in the present invention includes almost all organic compounds having one or more oxygen-oxygen bonds within the molecule, and examples thereof include methyl ethyl ketone peroxide, cyclohexanone peroxide, 3,3,5-trimethylcyclohexanone peroxide, methylcyclohexanone peroxide, acetylacetone peroxide, 1,1-bis(tert-butylperoxy)-3,3,5-trimethylcyclohexane, 1,1 -bis(tert-butylperoxy)cyclohexane, 2,2-bis(tert-butylperoxy)butane, tert-butyl hydroperoxide, cumene hydroperoxide, diisopropylbenzene hydroperoxide, paramethane hydroperoxide, 2,5-dimethylhexane-2,5-dihydroperoxide, 1,1,3,3-tetramethylbutyl hydroperoxide, di-tert-butyl peroxide, tert-butylcumyl peroxide, dicumyl peroxide, bis(tert-butylperoxyisopropyl)benzene, 2,5-dimethyl-2,5-di(tert-butylperoxy)hexane, 2,5-oxanoyl peroxide, succinic peroxide, benzoyl peroxide, 2,4-dichlorobenzoyl peroxide, meta-toluoyl peroxide, diisopropyl peroxydicarbonate, di-2-ethylhexyl peroxydicarbonate, di-2-ethoxyethyl peroxydicarbonate, dimethoxyisopropyl peroxycarbonate, di(3-methyl-3-methoxybutyl)peroxydicarbonate, tert-butyl peroxyacetate, tert-butyl peroxypivalate, tert-butyl peroxyneodecanoate, tert-butyl peroxyoctanoate, tert-butyl peroxy-3,5,5-trimethylhexanoate, tert-butyl peroxylaurate, tertiary carbonate, 3,3',4,4'-tetra-(tert-butylperoxycarbonyl)benzophenone, 3,3',4,4'-tetra-(tert-amylperoxycarbonyl)benzophenone, 3,3',4,4'-tetra-(tert-hexylperoxycarbonyl)benzophenone, 3,3',4,4'-tetra-(tert-octylperoxycarbonyl)benzophenone, 3,3',4,4'-tetra-(cumylperoxycarbonyl)benzophenone, 3,3',4,4'-tetra-(p-isopropylcumylperoxycarbonyl)benzophenone, carbonyldi(tert-butylperoxy dihydrogen diphthalate) and carbonyldi(tert-hexylperoxy dihydrogen diphthalate).

Among these, preferred are peroxide esters such as 3,3',4,4'-tetra-(tert-butylperoxycarbonyl)benzophenone, 3,3',4,4'-tetra-(tert-amylperoxycarbonyl)benzophenone, 3,3',4,4'-tetra-(tert-hexylperoxycarbonyl)benzophenone, 3,3',4,4'-tetra-(tert-octylperoxycarbonyl)benzophenone, 3,3',4,4'-tetra-(cumylperoxycarbonyl)benzophenone, 3,3',4,4'-tetra-(p-isopropylcumylperoxycarbonyl)benzophenone and di-tert-butyl diperoxyisophthalate.

### (d) Thio Compound

The (d) thio compound preferred as the radical initiator for use in the present invention includes compounds having a structure represented by the following formula (4): 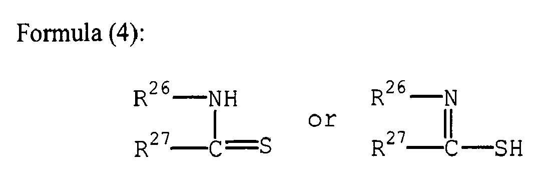 (wherein R²⁶ represents an alkyl group, an aryl group or a substituted aryl group, and R²⁷ represents a hydrogen atom or an alkyl group, or R²⁶ and R²⁷ each represents a nonmetallic atom group necessary for forming, when combined with each other, a 5- to 7-membered ring which may contain a heteroatom selected from oxygen atom, sulfur atom and nitrogen atom).

Specific examples of the thio compound represented by formula (4) include the following compounds.

| No. | R²⁶ | R²⁷ |
|---|---|---|
| 1 | -H | -H |
| 2 | -H | -CH₃ |
| 3 | -CH₃ | -H |
| 4 | -CH₃ | -CH₃ |
| 5 | -C₆H₅ | -C₂H₅ |
| 6 | -C₆H₅ | -C₄H₉ |
| 7 | -C₆H₄Cl | -CH₃ |
| 8 | -C₆H₄Cl | -C₄H₉ |
| 9 | -C₆H₄-CH₃ | -C₄H₉ |
| 10 | -C₆H₄-OCH₃ | -CH₃ |
| 11 | -C₆H₄-OCH₃ | -C₂H₅ |
| 12 | -C₆H₄-OC₂H₅ | -CH₃ |
| 13 | -C₆H₄-OC₂H₅ | -C₂H₅ |
| 14 | -C₆H₄-OCH₃ | -C₄H₉ |
| 15 | -(CH₂)₂- | |
| 16 | -(CH₂)₂-S- | |
| 17 | -CH(CH₃)-CH₂-S- | |
| 18 | -CH₂-CH(CH₃)-S- | |
| 19 | -C(CH₃)₂-CH₂-S- | |
| 20 | -CH₂-C(CH₃)₂-S- | |
| 21 | -(CH₂)₂-O- | |
| 22 | -CH(CH₃)-CH₂-O- | |
| 23 | -C(CH₃)₂-CH₂-O- | |
| 24 | -CH=CH-N(CH₃)- | |
| 25 | -(CH₂)₃-S- | |
| 26 | -(CH₂)₂-CH(CH₃)-S- | |
| 27 | -(CH₂)₃-O- | |
| 28 | -(CH₂)₅- | |
| 29 | -C₆H₄-O- | |
| 30 | -N=C(SCH₃)-S- | |
| 31 | -C₆H₄-NH- | |
| 32 | 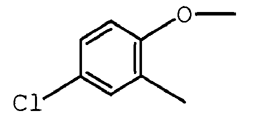 | |

### (e) Hexaarylbiimidazole Compound

The (e) hexaarylbiimidazole compound preferred as the radical initiator for use in the present invention includes lophine dimers described in JP-B-45-37377 and JP-B-44-86516, such as 2,2'-bis(o-chlorophenyl)-4,4',5,5'-tetraphenylbiimidazole, 2,2'-bis(o-bromophenyl)-4,4',5,5'-tetraphenylbiimidazole, 2,2'-bis(o,p-dichlorophenyl)-4,4',5,5'-tetraphenylbiimidazole, 2,2'-bis(o-chlorophenyl)-4,4',5,5'-tetra(m-methoxyphenyl)biimidazole, 2,2'-bis(o,o'-dichlorophenyl)-4,4',5,5'-tetraphenylbiimidazole, 2,2'-bis(o-nitrophenyl)-4,4',5,5'-tetraphenylbiimidazole, 2,2'-bis(o-methylphenyl)-4,4',5,5'-tetraphenylbiimidazole and 2,2'-bis(o-trifluorophenyl)-4,4',5,5'-tetraphenylbiimidazole.

### (f) Ketooxime Ester Compound

Examples of (f) the ketooxime ester compound preferred as the radical initiator for use in the present invention include 3-benzoyloxyiminobutan-2-one, 3-acetoxyiminobutan-2-one, 3-propionyloxyiminobutan-2-one, 2-acetoxyiminopentan-3-one, 2-acetoxyimino-1-phenylpropan-1-one, 2-benzoyloxyimino-1-phenylpropan-1-one, 3-p-toluenesulfonyloxyiminobutan-2-one and 2-ethoxycarbonyloxyimino-1-phenylpropan-1-one.

### (g) Borate Compound

Examples of (g) the borate compound preferred as the radical initiator for use in the present invention include a compound represented by the following formula (5): 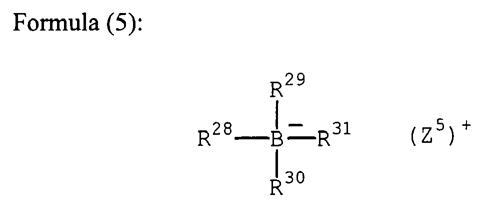 (wherein R²⁸, R²⁹, R³⁰ and R³¹, which may be the same or different, each represents a substituted or unsubstituted alkyl group, a substituted or unsubstituted aryl group, a substituted or unsubstituted alkenyl group, a substituted or unsubstituted alkynyl group, or a substituted or unsubstituted heterocyclic group, two or more groups of R²⁸, R²⁹, R³⁰ and R³¹ may combine to form a cyclic structure, provided that at least one of R²⁸, R²⁹, R³⁰ and R³¹ is a substituted or unsubstituted alkyl group, and (Z⁵)⁺ represents an alkali metal cation or a quaternary ammonium cation).

Specific examples of the compound represented by formula (5) include compounds described in U.S. Patents 3,567,453 and 4,343,891, and European Patents 109,772 and 109,773, and the following compounds.

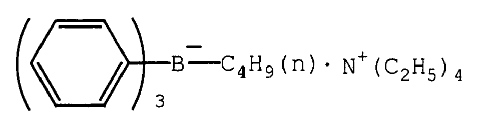

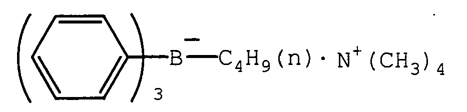

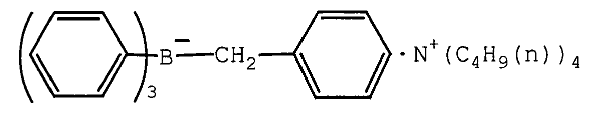

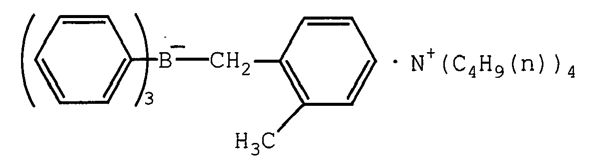

### (h) Azinium Compound

The (h) azinium salt compound preferred as the radical initiator for use in the present invention includes a group of compounds having an N-O bond described in JP-A-63-138345, JP-A-63-142345, JP-A-63-142346, JP-A-63-143537 and JP-B-46-42363.

### (i) Metallocene Compound

The (i) metallocene compound preferred as the radical initiator for use in the present invention includes titanocene compounds described in JP-A-59-152396, JP-A-61-151197, JP-A-63-41484, JP-A-2-249 and JP-A-2-4705, and iron-arene complexes described in JP-A-1-304453 and JP-A-1-152109.

Specific examples of the titanocene compound include dicyclopentadienyl-Ti-dichloride, dicyclopentadienyl-Ti-bisphenyl, dicyclopentadienyl-Ti-bis-2,3,4,5,6-pentafluorophen-1-yl, dicyclopentadienyl-Ti-bis-2,3,5,6-tetrafluorophen-1-yl, dicyclopentadienyl-Ti-bis-2,4,6-trifluorophen-1-yl, dicyclopentadienyl-Ti-bis-2,6-difluorophen-1-yl, dicyclopentadienyl-Ti-bis-2,4-difluorophen-1-yl, dimethylcyclopentadienyl-Ti-bis-2,3,4,5,6-pentafluorophen-1-yl, dimethylcyclopentadienyl-Ti-bis-2,3,5,6-tetrafluorophen-1-yl, dimethylcyclopentadienyl-Ti-bis-2,4-difluorophen-1-yl, bis(cyclopentadienyl)-bis(2,6-difluoro-3-(pyr-1-yl)phenyl)titanium, bis(cyclopentadienyl)bis[2,6-difluoro-3-(methylsulfonamido)phenyl]titanium, bis(cyclopentadienyl)bis[2,6-difluoro-3-(N-butylbialloylamino)phenyl]titanium, bis-(cyclopentadienyl)bis[2,6-difluoro-3-(N-butyl-(4-chlorobenzoyl)amino)phenyl]titanium, bis(cyclopentadienyl)bis[2,6-difluoro-3-(N-benzyl-2,2-dimethylpropanoylamino)-phenyl]titanium, bis(cyclopentadienyl)bis[2,6-difluoro-3-(N-(2-ethylhexyl)-4-tolylsulfonyl)amino]phenyl]titanium, bis(cyclopentadienyl)bis[2,6-difluoro-3-(N-(3-oxaheptyl)benzoylamino)phenyl)titanium, bis(cyclopentadienyl)bis[2,6-difluoro-3-(N-(3,6-dioxadecyl)benzoylamino)phenyl]titanium, bis(cyclopentadienyl)bis[2,6-difluoro-3-(trifluoromethylsulfonyl)amino)phenyl]titanium, bis(cyclopentadienyl)bis[2,6-difluoro-3-(trifluoroacetylamino)phenyl]titanium, bis(cyclopentadienyl)bis[2,6-difluoro-3-(2-chlorobenzoyl)amino]phenyl]titanium, bis(cyclopentadienyl)bis[2,6-difluoro-3-(4-chlorobenzoyl)amino]phenyl]titanium, bis(cyclopentadienyl)bis[2,6-difluoro-3-(N-(3,6-dioxadecyl)-2,2-dimethylpentanoylamino)phenyl]titanium, bis(cyclopentadienyl)bis[2,6-difluoro-3-(N-(3,7-dimethyl-7-methoxyoctyl)benzoylamino)phenyl]titanium and bis(cyclopentadienyl)bis[2,6-difluoro-3-(N-cyclohexylbenzoylamino)phenyl]titanium.

### (j) Active Ester Compound

The (j) active ester compound preferred as the radical initiator for use in the present invention include imidosulfonate compounds described in JP-B-62-6223, and active sulfonates described in JP-B-63-14340 and JP-A-59-174831.

### (k) Compound Having Carbon-Halogen Bond

The (k) compound having a carbon-halogen bond preferred as the radical initiator for use in the present invention includes those represented by the following formulae (6) to (12): 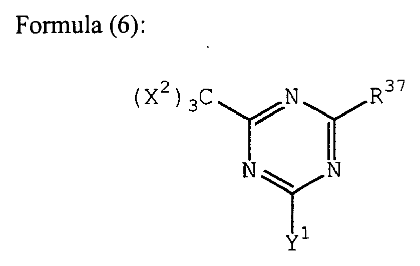 (wherein X² represents a halogen atom, Y¹ represents -C(X²)₃, -NH₂, -NHR³⁸, -NR³⁸ or -OR³⁸, R³⁸ represents an alkyl group, a substituted alkyl group, an aryl group or a substituted aryl group, and R³⁷ represents -C(X²)₃, an alkyl group, a substituted alkyl group, an aryl group, a substituted aryl group or a substituted alkenyl group); 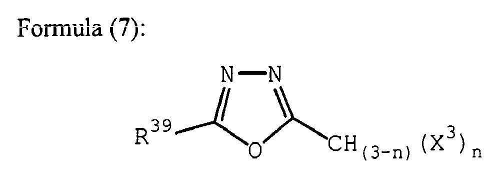 (wherein R³⁹ represents an alkyl group, a substituted alkyl group, an alkenyl group, a substituted alkenyl group, an aryl group, a substituted aryl group, a halogen atom, an alkoxy group, a substituted alkoxyl group, a nitro group or a cyano group, X³ represents a halogen atom, and n represents an integer of 1 to 3);

Formula (8):

R⁴⁰-Z⁶-CH ₍₂₋ₘ₎ (X³)ₘR⁴¹

(wherein R⁴⁰ represents an aryl group or a substituted aryl group, R⁴¹ represents a group shown below or a halogen, Z⁶ represents -C(=O)-, -C(=S)- or -SO₂-, X³ represents a halogen atom, and m represents 1 or 2): 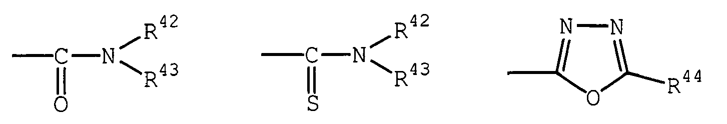 (wherein R⁴² and R⁴³ each represents an alkyl group, a substituted alkyl group, an alkenyl group, a substituted alkenyl group, an aryl group or a substituted aryl group, R⁴⁴ has the same meaning as R³⁸ in formula (6)); 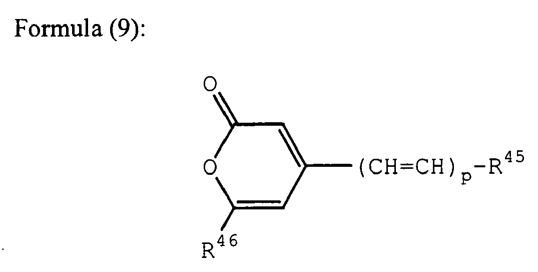 (wherein R⁴⁵ represents an aryl group which may be substituted or a heterocyclic group which may be substituted, R⁴⁶ represents a trihaloalkyl or trihaloalkenyl group having a carbon number of 1 to 3, and p represents 1, 2 or 3); 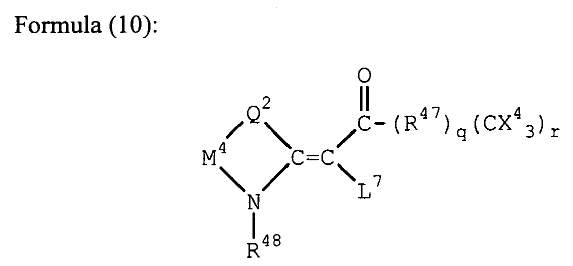 (formula (10) represents a carbonylmethylene heterocyclic compound having a trihalogenomethyl group; wherein L⁷ represents a hydrogen atom or a substituent represented by the formula: CO-(R⁴⁷)_{q}(C(X⁴)₃)ᵣ, Q² represents a sulfur atom, a selenium atom, an oxygen atom, a dialkylmethylene group, an alken-1,2-ylene group, a 1,2-phenylene group or an N-R group, M⁴ represents a substituted or unsubstituted alkylene or alkenylene group, or a 1,2-arylene group, R⁴⁸ represents an alkyl group, an aralkyl group or an alkoxyalkyl group, R⁴⁷ represents a carbocyclic or heterocyclic divalent aromatic group, X⁴ represents a chlorine atom, a bromine atom or an iodine atom, and q=0 and r=1, or q=1 and r=1 or 2); 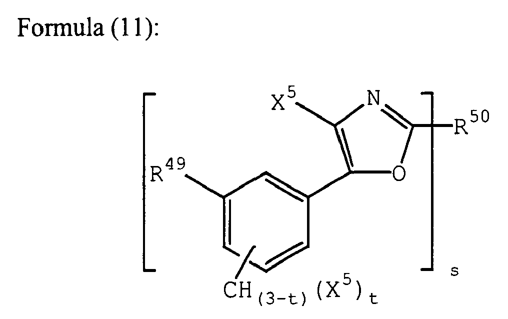 (formula (11) represents a 4-halogeno-5-(halogenomethyl-phenyl)oxazole derivative; wherein X⁵ represents a halogen atom, t represents an integer of 1 to 3, s represents an integer of 1 to 4, R⁴⁹ represents a hydrogen atom or a CH₃₋ₜX⁵ₜ group, and R⁵⁰ represents an s-valent unsaturated organic group which may be substituted); and 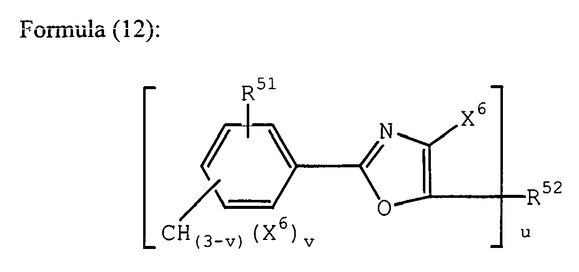 (formula (12) represents a 2-(halogenomethylphenyl)-4-halogeno-oxazole derivative; wherein X⁶ represents a halogen atom, v represents an integer of 1 to 3, u represents an integer of 1 to 4, R⁵¹ represents a hydrogen atom or a CH₃₋ᵥX⁶ᵥ group, and R⁵² represents a u-valent unsaturated organic group which may be substituted).

Specific examples of the compound having a carbon-halogen bond include compounds described in Wakabayashi et al, Bull. Chem. Soc. Japan, 42, 2924 (1969), such as 2-phenyl-4,6-bis(trichloromethyl)-S-triazine, 2-(p-chlorophenyl)-4,6-bis(trichloromethyl)-S-triazine, 2-(p-tolyl)-4,6-bis(trichloromethyl)-S-triazine, 2-(p-methoxyphenyl)-4,6-bis(trichloromethyl)-S-triazine, 2-(2',4'-dichlorophenyl)-4,6-bis(trichloromethyl)-S-triazine, 2,4,6-tris(trichloromethyl)-S-triazine, 2-methyl-4,6-bis(trichloromethyl)-S-triazine, 2-n-nonyl-4,6-bis(trichloromethyl)-S-triazine and 2-(α,α,β-trichloroethyl)-4,6-bis(trichloromethyl)-S-triazine; compounds described in British Patent 1,388,492, such as 2-styryl-4,6-bis(trichloromethyl)-S-triazine, 2-(p-methylstyryl)-4,6-bis(trichloromethyl)-S-triazine, 2-(p-methoxystyryl)-4,6-bis(trichloromethyl)-S-triazine and 2-(p-methoxystyryl)-4-amino-6-trichloromethyl-S-triazine; compounds described in JP-A-53-133428, such as 2-(4-methoxynaphtho-1-yl)-4,6-bis-trichloromethyl-S-triazine, 2-(4-ethoxynaphtho-1-yl)-4,6-bis-trichloromethyl-S-triazine, 2-[4-(2-ethoxyethyl)naphtho-1-yl]-4,6-bis-trichloromethyl-S-triazine, 2-(4,7-dimethoxynaphtho-1-yl)-4,6-bis-trichloromethyl-S-triazine and 2-(acenaphtho-5-yl)-4,6-bis-trichloromethyl-S-triazine; compounds described in German Patent No. 3,337,024, such as compounds shown below; and compounds which can be easily synthesized by one skilled in the art according to the synthesis method described in M.P. Hutt, E.F. Elslager and L.M. Herbel, Journal of Heterocyclic Chemistry, Vol. 7 (No. 3), page 511 et seq. (1970), such as compounds shown below.

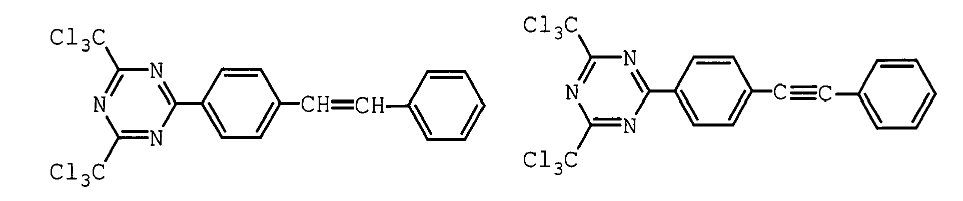

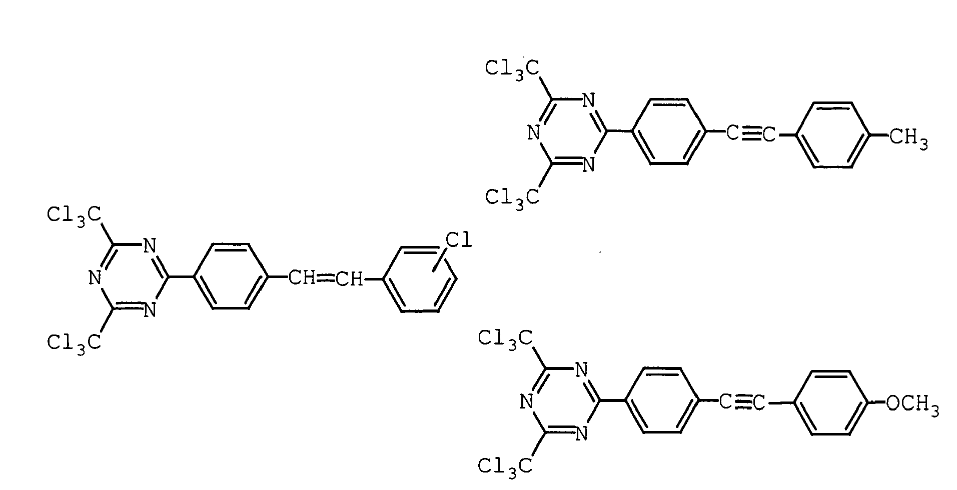

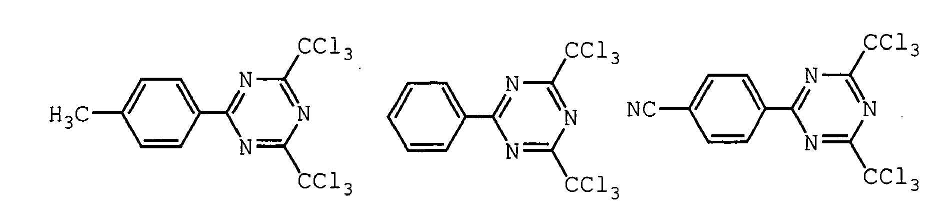

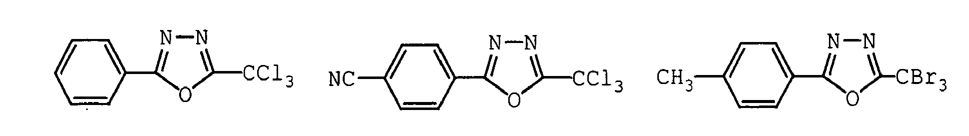

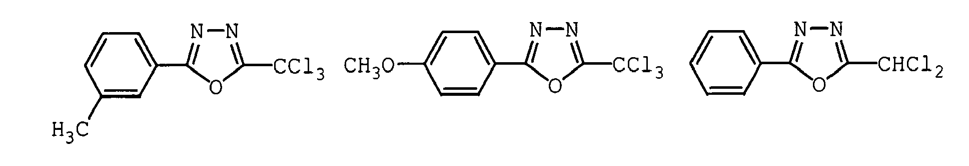

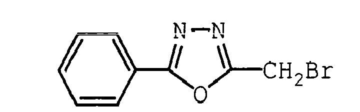

### (1) Azo-Based Compound

Examples of (1) the azo-based compound preferred as the radical initiator for use in the present invention include 2,2'-azobisisobutyronitrile, 2,2'-azobispropionitrile, 1,1'-azobis(cyclohexane-1 -carbonitrile), 2,2'-azobis(2-methylbutyronitrile), 2,2'-azobis(2,4-dimethylvaleronitrile), 2,2'-azobis(4-methoxy-2,4-dimethylvaleronitrile), 4,4'-azobis(4-cyanovaleric acid), dimethyl 2,2'-azobisisobutyrate, 2,2'-azobis(2-methypropionamidooxime), 2,2'-azobis[2-(2-imidazolin-2-yl)propane], 2,2'-azobis{2-methyl-N-[1,1-bis(hydroxymethyl)-2-hydroxyethyl]propionamide}, 2,2'-azobis[2-methyl-N-(2-hydroxyethyl)propionamide], 2,2'-azobis(N-butyl-2-methylpropionamide), 2,2'-azobis(N-cyclohexyl-2-methylpropionamide), 2,2'-azobis[N-(2-propenyl)-2-methylpropionamide] and 2,2'-azobis(2,4,4-trimethylpentane).

More preferred examples of the radical initiator for use in the present invention include those (a) aromatic ketones, (b) onium salt compounds, (c) organic peroxides, (e) hexaarylbiimidazole compounds, (i) metallocene compounds, and (k) compounds having a carbon-halogen bond, and most preferred examples thereof include aromatic iodonium salts, aromatic sulfonium salts, titanocene compounds and trihalomethyl-S-triazine compounds represented by formula (6).

The initiator may be added in a ratio of generally from 0.1 to 50 mass%, preferably from 0.5 to 30 mass%, more preferably from 5 to 20 mass%, based on the entire solid content of the decomposable resin composition.

The initiators for use in the present invention are suitably used individually or in combination of two or more thereof.

### Other Components:

In the decomposable resin composition of the present invention, other components suitable for the usage, production method and the like may be further appropriately added. Preferred examples of the additive are described below.

### <Sensitizing Dye>

In the present invention, when a laser of emitting an infrared ray at 760 to 1,200 nm (e.g., YAG laser, semiconductor laser) is employed as the light source, an infrared absorbent is usually used. The infrared absorbent absorbs laser light and generates heat to accelerate the thermal decomposition. The infrared absorbent used in the present invention is a dye or pigment having an absorption maximum at a wavelength of 760 to 1,200 nm.

As for the dye, commercially available dyes and known dyes described in publications such as Senryo Binran (Handbook of Dyes) (compiled by The Synthetic Organic Chemistry, Japan (1970)) may be used. Specific examples thereof include a dye such as azo dye, metal complex salt azo dye, pyrazolone azo dye, naphthoquinone dye, anthraquinone dye, phthalocyanine dye, carbonium dye, quinoneimine dye, methine dye, cyanine dye, squarylium dye, pyrylium salt and metal thiolate complex.

Preferred examples of the dye include cyanine dyes described in JP-A-58-125246, JP-A-59-84356, JP-A-59-202829 and JP-A-60-78787, methine dyes described in JP-A-58-173696, JP-A-58-181690 and JP-A-58-194595, naphthoquinone dyes described in JP-A-58-112793, JP-A-58-224793, JP-A-59-48187, JP-A-59-73996, JP-A-60-52940 and JP-A-60-63744, squarylium dyes described in JP-A-58-112792, and cyanine dyes described in British Patent 434,875.

Also, near infrared absorbing sensitizers described in U.S. Patent 5,156,938 may be suitably used. Furthermore, substituted arylbenzo(thio)pyrylium salts described in U.S. Patent 3,881,924, trimethinethiapyrylium salts described in JP-A-57-142645 (corresponding to U.S. Patent 4,327,169), pyrylium-based compounds described in JP-A-58-181051, JP-A-58-220143, JP-A-59-41363, JP-A-59-84248, JP-59-84249, JP-A-59-146063 and JP-A-59-146061, cyanine dyes described in JP-A-59-216146, pentamethinethiopyrylium salts described in U.S. Patent 4,283,475, and pyrylium compounds described in JP-B-S-13514 and JP-B-5-19702 may also be preferably used. Other preferred examples of the dye include near infrared absorbing dyes represented by formulae (I) and (II) of U.S. Patent 4,756,993.

Also, other preferred examples of the infrared absorbing dye for use in the present invention include specific indolenine cyanine dyes described in JP-A-2002-278057.

Among these dyes, preferred are a cyanine dye, a squarylium dye, a pyrylium salt, a nickel thiolate complex and an indolenine cyanine dye, more preferred are a cyanine dye and an indolenine cyanine dye.

Specific examples of the cyanine dye which can be suitably used in the present invention include those described in JP-A-2001-133969 (paragraphs [0017] to [0019]), JP-A-2002-40638 (paragraphs [0012] to [0038]), and JP-A-2002-23360 (paragraphs [0012] to [0023]).

The coloring matter represented by the following formula (d) or (e) is preferred in view of light-to-heat conversion.

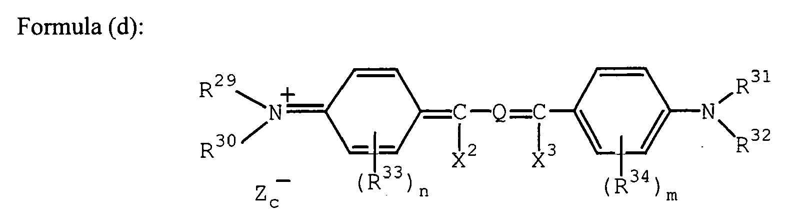

In formula (d), R²⁹ to R³¹ each independently represents a hydrogen atom, an alkyl group or an aryl group. R³³ and R³⁴ each independently represents an alkyl group, a substituted oxy group or a halogen atom. n and m each independently represents an integer of 0 to 4. The pair of R²⁹ and R³⁰ or the pair of R³¹ and R³² may combine with each other to form a ring. Also, R²⁹ and/or R³⁰ may combine with R³³ to form a ring, or R³¹ and/or R³² may combine with R³⁴ to form a ring. In the case where a plurality of R³³s or R³⁴s are present, R³³s or R³⁴s may combine with each other to form a ring. X² and X³ each independently represents a hydrogen atom, an alkyl group or an aryl group, provided that at least one of X² and X³ represents a hydrogen atom or an alkyl group. Q represents a trimethine group which may have a substituent or a pentamethine group which may have a substituent or may form a ring structure together with a divalent organic group. Zc⁻ represents a counter anion. However, Zc⁻ is not necessary when the coloring matter represented by formula (d) has an anionic substituent in its structure and neutralization of charge is not needed. In view of storage stability of the coating solution for the photosensitive layer, Zc⁻ is preferably a halogen ion, a perchlorate ion, a tetrafluoroborate ion, a hexafluorophosphate ion or a sulfonate ion, more preferably a perchlorate ion, a hexafluorophosphate ion or an arylsulfonate ion.

Specific examples of the dye represented by formula (d) which can be suitably used in the present invention include those shown below.

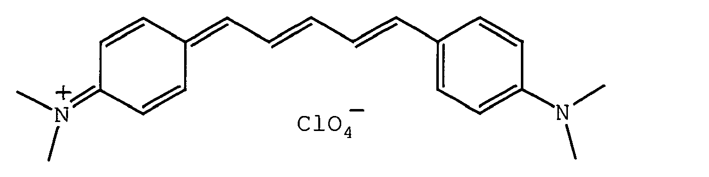

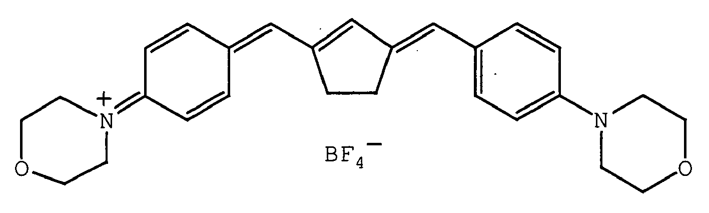

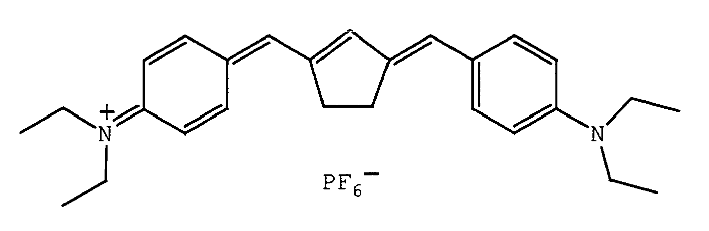

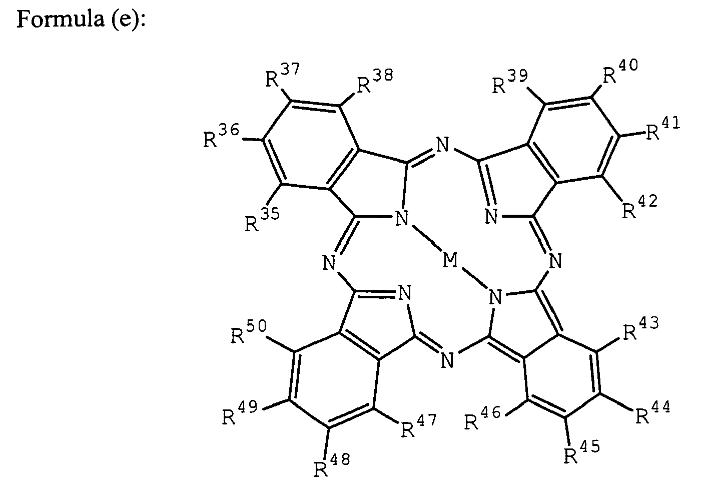

In formula (e), R³⁵ to R⁵⁰ each independently represents a hydrogen atom, a halogen atom, a cyano group, an alkyl group, an aryl group, an alkenyl group, an alkynyl group, a hydroxy group, a carbonyl group, a thio group, a sulfonyl group, a sulfinyl group, an oxy group, an amino group or an onium salt structure. These groups each may have a substituent when a substituent can be introduced thereinto. M represents two hydrogen atoms, a metal atom, a halometal group or an oxymetal group, and examples of the metal atom contained therein include atoms of Groups IA, IIA, IIIB and IVB of the Periodic Table, transition metals of first, second and third periods, and lanthanoid element. Among these, copper, magnesium, iron, zinc, cobalt, aluminum, titanium and vanadium are preferred.

Specific examples of the dye represented by formula (e) which can be suitably used in the present invention include those shown below.

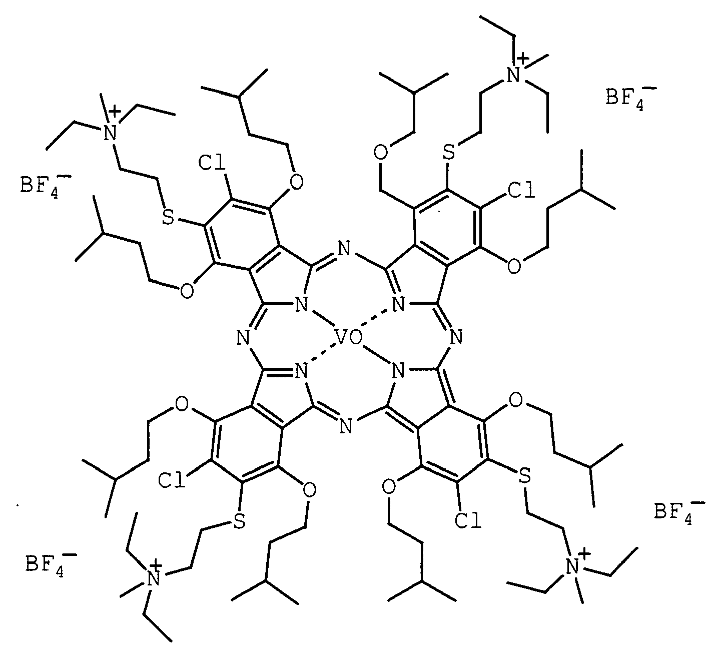

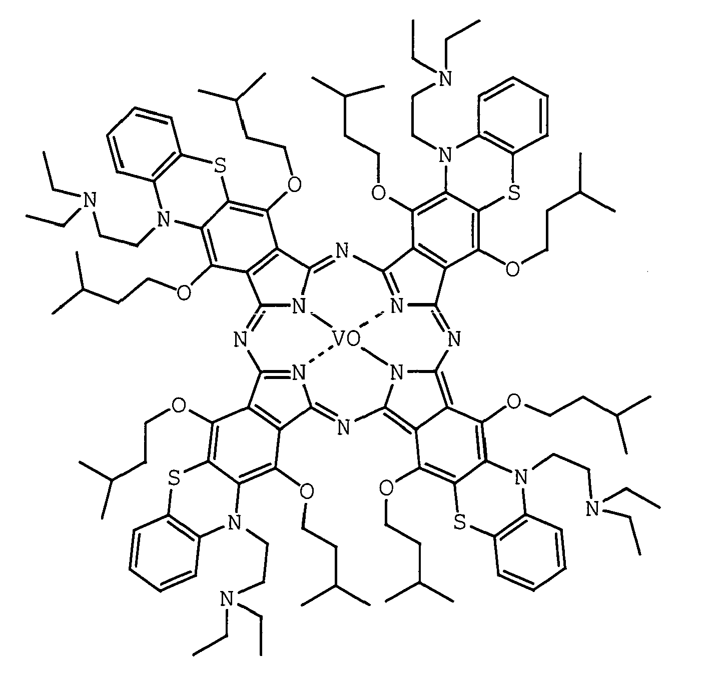

As regards the pigment for use in the present invention, commercially available pigments and pigments described in Color Index (C.I.) Binran (C.I. Handbook), Saishin Ganryo Binran (Handbook of Newest Pigments), compiled by Nippon Ganryo Gijutsu Kyokai (1977), Saishin Ganryo Oyo Gijutsu (Newest Pigment Application Technology), CMC (1986), and Insatsu Ink Gijutsu (Printing Ink Technology), CMC (1984) can be used.

The kind of the pigment includes a black pigment, a yellow pigment, an orange pigment, a brown pigment, a red pigment, a violet pigment, a blue pigment, a green pigment, a fluorescent pigment, a metal powder pigment and a polymer bond coloring matter. Specific examples of the pigment which can be used include an insoluble azo pigment, an azo lake pigment, a condensed azo pigment, a chelate azo pigment, a phthalocyanine-based pigment, an anthraquinone-based pigment, a perylene- or perynone-based pigment, a thioindigo-based pigment, a quinacridone-based pigment, a dioxazine-based pigment, an isoindolinone-based pigment, a quinophthalone-based pigment, a dyed lake pigment, an azine pigments, a nitroso pigment, a nitro pigment, a natural pigment, a fluorescent pigment, an inorganic pigment and carbon black. Among these pigments, carbon black is preferred.

These pigments each may or may not be surface-treated before use. The surface treatment may be performed, for example, by a method of coating the surface with resin or wax, a method of attaching a surfactant, or a method of bonding a reactive substance (for example, a silane coupling agent, an epoxy compound or polyisocyanate) to the pigment surface. These surface treatment methods are described in Kinzoku Sekken no Seishitsu to Oyo (Properties and Applications of Metal Soap), Saiwai Shobo, Insatsu Ink Gijutsu (Printing Ink Technology), CMC (1984), and Saishin Ganryo Oyo Giiutsu (Newest Pigment Application Technology), CMC (1986).

The particle size of the pigment is preferably from 0.01 to 10 µm, more preferably from 0.05 to 1 µm, still more preferably from 0.1 to 1 µm. When the particle size of the pigment is 0.01 µm or more, stability of the dispersion in the coating solution is increased, whereas when it is 10 µm or less, good uniformity of the resin composition layer is obtained.

As regards the method of dispersing the pigment, known dispersion techniques employed, for example, in the production of ink or toner may be used. Examples of the dispersing machine include ultrasonic disperser, sand mill, attritor, pearl mill, super-mill, ball mill, impeller, disperser, KD mill, colloid mill, dynatron, three-roll mill and pressure kneader. These are described in detail in Saishin Ganryo Oyo Giiutsu (Newest Pigment Application Technology), CMC (1986).

### <Co-Sensitizer>

The sensitivity at the time of photo-curing the resin composition layer can be further enhanced by using a certain additive (hereinafter referred to as a "co-sensitizer"). The operation mechanism of the co-sensitizer is not clearly known but is considered to be mostly based on the following chemical process. That is, the co-sensitizer reacts with various intermediate active species (e.g., radical, cation) generated in the process of a photo-reaction initiated by the photopolymerization initiator and a subsequent addition-polymerization reaction to produce new active radicals. The co-sensitizers are roughly classified into (a) a compound which is reduced to produce an active radical, (b) a compound which is oxidized to produce an active radical, and (c) a compound which reacts with a radical having low activity to convert it into a more highly active radical or acts as a chain transfer agent. However, in many cases, a common view regarding to which type individual compounds belong is not present.

### (a) Compound which is reduced to produce an active radical

### Compound having a carbon-halogen bond:

An active radical is considered to be generated resulting from reductive cleavage of the carbon-halogen bond. Specific examples of this compound which can be suitably used include trihalomethyl-s-triazines and trihalomethyloxadiazoles.

### Compound having a nitrogen-nitrogen bond:

An active radical is considered to be generated resulting from reductive cleavage of the nitrogen-nitrogen bond. Specific examples of this compound which can be suitably used include hexaarylbiimidazoles.

### Compound having an oxygen-oxygen bond:

An active radical is considered to be generated resulting from reductive cleavage of the oxygen-oxygen bond. Specific examples of this compound which can be suitably used include organic peroxides.

### Onium compound:

An active radical is considered to be generated resulting from reductive cleavage of a carbon-hetero bond or an oxygen-nitrogen bond. Specific examples of this compound which can be suitably used include diaryliodonium salts, triarylsulfonium salts and N-alkoxypyridinium (azinium) salts.

### Ferrocene and iron arene complexes:

An active radical is reductively produced.

### (b) Compound which is oxidized to produce an active radical

### Alkylate complex:

An active radical is considered to be generated resulting from oxidative cleavage of a carbon-hetero bond. Specific examples of this compound which can be suitably used include triaryl alkylborates.

### Alkylamine compound:

An active radical is considered to be generated resulting from oxidative cleavage of a C-X bond on the carbon adjacent to nitrogen. X is preferably, for example, a hydrogen atom, a carboxyl group, a trimethylsilyl group or a benzyl group. Specific examples of this compound include ethanolamines, N-phenylglycines and N-trimethylsilylmethylanilines.

### Sulfur-containing or tin-containing compound:

The above-described amines in which the nitrogen atom is replaced with a sulfur atom or a tin atom can produce an active radical by the same action. Also, a compound having an S-S bond is known to effect sensitization by the S-S cleavage.

### α-Substituted methylcarbonyl compound:

An active radical can be produced resulting from oxidative cleavage of the bond between carbonyl-α carbon. The compound in which the carbonyl is converted into an oxime ether also shows the same activity. Specific examples of this compound include 2-alkyl-1-[4-(alkylthio)phenyl]-2-morpholinopronone-1 compounds and oxime ethers obtained by reacting such a compound with hydroxyamines and then etherifying the N-OH.

### sulfinic acid salts:

An active radical can be reductively produced. Specific examples of this compound include sodium arylsulfinate.

### (c) Compound which reacts with a radical to convert it into a more highly active radical or acts as a chain transfer agent

For example, compounds having SH, PH, SiH or GeH in the molecule may be used. Such a compound can produce a radical by donating hydrogen to a low-activity radical species or by being oxidized and then removing a proton. Specific examples of this compound include 2-mercaptobenzothiazoles, 2-mercaptobenzoxazoles and 2-mercaptobenzimidazoles.

A large number of examples of the co-sensitizer are more specifically described, for example, in JP-A-9-236913 as an additive for enhancing the sensitivity, and these can be applied also to the present invention. Some of these are set forth below, but the present invention is not limited thereto. In the formula below, -TMS indicates a trimethylsilyl group.

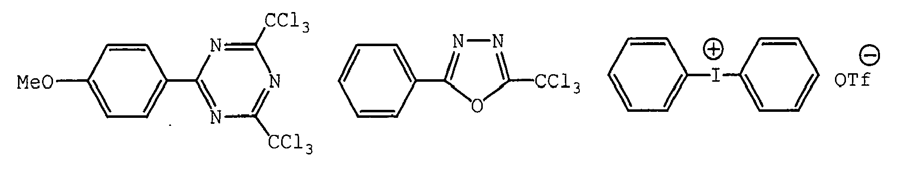

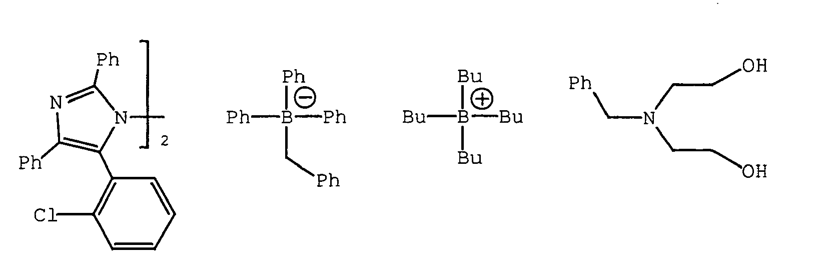

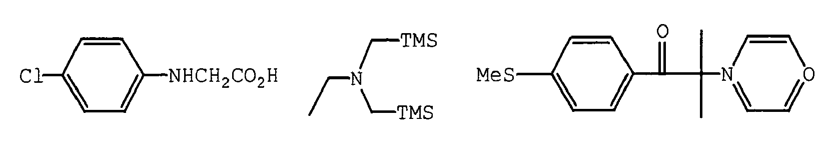

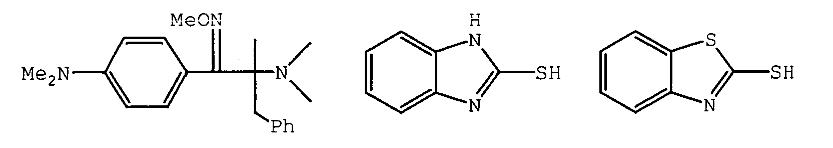

Similarly to the above-described sensitizing dye, the co-sensitizer can be subjected to various chemical modifications so as to improve the characteristics of the resin composition layer. For example, methods such as binding to the sensitizing dye, initiator compound, addition-polymerizable unsaturated compound or other parts, introduction of a hydrophilic moiety, introduction of a substituent for enhancing the compatibility or inhibiting the crystal deposition, introduction of a substituent for enhancing the adhesion property, and formation of a polymer, may be used.

The co-sensitizers may be used individually or in combination of two or more thereof. The amount of the co-sensitizer used is from 0.05 to 100 parts by mass, preferably from 1 to 80 parts by mass, more preferably from 3 to 50 parts by mass, per 100 parts by mass of the compound having an ethylenically unsaturated double bond.

### <Polymerization Inhibitor>

In the present invention, in addition to these components, a small amount of a thermopolymerization inhibitor is preferably added so as to prevent unnecessary thermopolymerization of the polymerizable ethylenically unsaturated double bond-containing compound during the production or storage of the composition. Suitable examples of the thermopolymerization inhibitor include hydroquinone, p-methoxyphenol, di-tert-butyl-p-cresol, pyrogallol, tert-butyl catechol, benzoquinone, 4,4'-thiobis(3-methyl-6-tert-butylphenol), 2,2'-methylenebis(4-methyl-6-tertbutylphenol) and N-nitrosophenylhydroxyamine cerous salt. The amount of the thermopolymerization inhibitor added is preferably from about 0.01 to about 5 mass% based on the mass of the entire composition. Also, if desired, a higher fatty acid derivative or the like, such as behenic acid and behenic acid amide, may be added and allowed to localize on the layer surface in the process of drying after coating on a support or the like so as to prevent polymerization inhibition by oxygen. The amount of the higher fatty acid derivative added is preferably from about 0.5 to about 10 mass% based on the entire composition.

### <Colorant>

Furthermore, a colorant such as dye and pigment may be added for the purpose of coloring the resin composition layer. By this addition, properties such as visibility of the image part or suitability for the image densitometer can be enhanced. As for the colorant, use of a pigment is particularly preferred. Specific examples of the colorant include pigments such as phthalocyanine-based pigment, azo-based pigment, carbon black and titanium oxide, and dyes such as Ethyl Violet, Crystal Violet, azo-based dye, anthraquinone-based dye and cyanine-based dye. The amount of the colorant added is preferably from about 0.5 to about 5 mass% based on the entire composition.

### <Other Additives>

Furthermore, known additives such as filler and plasticizer may be added for improving the physical properties of the cured film.

The filler may be an organic compound, an inorganic compound or a mixture thereof. Examples of the organic compound include carbon black, carbon nanotube, fullerene and graphite. Examples of the inorganic compound include silica, alumina, aluminum and calcium carbonate.

Examples of the plasticizer include dioctyl phthalate, didodecyl phthalate, triethylene glycol dicaprylate, dimethyl glycol phthalate, tricresyl phosphate, dioctyl adipate, dibutyl sebacate and triacetyl glycerin, and when a binder is used, the plasticizer may be added in an amount of 10 mass% or less based on the total mass of the ethylenically unsaturated double bond-containing compound and the binder.

### <Pattern-Forming Material>

The pattern-forming material of the present invention is characterized by having a layer comprising the laser-decomposable resin composition of the present invention on a support. The layer comprising a laser-decomposable resin composition (hereinafter sometimes referred to as a pattern-forming layer) contains at least the components (A) and (B), and the pattern-forming layer may further contain the above-described polymerizable compound and initiator and other components, if desired. Also, the pattern-forming layer may be a layer formed by previously curing the laser-decomposable resin composition before laser decomposition.

The pattern-forming material as used herein means a pattern-forming material which becomes a corrugated pattern after laser exposure that triggers the exposed area to form a trough as compared with the unexposed area. Accordingly, the pattern-forming material includes not only a type of pattern-forming material which forms directly (for example, through ablation) a trough by laser exposure, but also a type of pattern-forming material which forms a trough when subjected to a heat treatment or a development processing with an aqueous alkali solution or the like after laser exposure. The pattern-forming material of the present invention can be suitably used as the former type of pattern-forming material.

The pattern-forming material suitably used in the present invention is not particularly limited in its usage as long as it has the above-described property, and is applicable in various uses such as printing plate precursor (e.g., lithographic, gravure, letterpress, screen), printed wiring board, semiconductor photoresist material and optical disc recording material. In the present invention, the pattern-forming material of the present invention is preferably used as a printing plate for the laser direct-engraving plate making, that is, so-called "laser engraving", more preferably as a flexographic printing plate, and most preferably as a flexographic printing plate precursor for laser engraving.

### (Support)

In the present invention, a material having flexibility and excellent dimensional stability is preferably used for the support of the pattern-forming material, and examples thereof include a polyethylene terephthalate film, a polyethylene naphthalate film, a polybutylene terephthalate film and a polycarbonate film. In view of mechanical properties, shape stability, handleability and the like of the pattern-forming material, the thickness of the support is preferably from 50 to 350 µm, more preferably from 100 to 250 µm. Also, in order to enhance the adhesion between the support and the pattern-forming layer, a known adhesive layer conventionally used for such a purpose may be provided on the support surface, if desired.

Furthermore, the adhesive property to the pattern-forming layer or adhesive layer can be enhanced by applying a physical or chemical treatment to the surface of the support for use in the present invention. Examples of the physical treatment include a sand blast method, a wet blast method of jetting a fine particle-containing liquid, a corona discharge treatment, a plasma treatment, and an ultraviolet ray or vacuum ultraviolet ray irradiation treatment. Examples of the chemical treatment include a strong acid treatment, a strong alkali treatment, an oxidant treatment, and a coupling agent treatment.

### (Formation of Film)

In order to shape the decomposable resin composition of the present invention into a sheet form, a roll form or a cylindrical form, an existing resin-shaping method can be used. Examples thereof include a casting method and a method of extruding the resin composition from a nozzle or die by using a machine such as pump or extruder and adjusting the thickness with a blade or through calendering by a roller. At this time, the shaping can also be performed under heating within the range of not impairing the performance of the resin composition. If desired, a rolling treatment, a grinding treatment or the like may also be applied. In many cases, the resin composition is usually shaped on an underlay called a back film comprising a material such as PET and nickel. Furthermore, a cylindrical substrate made of fiber reinforced plastic (FRP), plastic or metal can also be used.

A hollow cylindrical support having a constant thickness can be used for reducing the weight. The role of the back film or cylindrical substrate is to ensure the dimensional stability of the pattern-forming material. Accordingly, a material having high dimensional stability should be selected. Specific examples of the material include a polyester resin, a polyimide resin, a polyamide resin, polyamideimide resin, a polyetherimide resin, polybismaleimide resin, a polysulfone resin, a polycarbonate resin, a polyphenylene ether resin, a polyphenylene thioether resin, a polyethersulfone resin, a crystalline resin comprising wholly aromatic polyester resin, a wholly aromatic polyamide resin, and an epoxy resin. These resins may be used in the form of a laminate. For example, a sheet obtained by stacking a polyethylene terephthalate layer having a thickness of 50 µm on both surfaces of a wholly aromatic polyamide film having a thickness of 4.5 µm may also be used. Furthermore, a porous sheet, for example, a cloth formed by knitting fibers, a nonwoven fabric or a film having formed therein fine pores, can be used as the back film. In the case of using a porous sheet as the back film, a high adhesive property for integrating the photosensitive resin cured layer and the back film can be obtained by impregnating the pores with the photosensitive resin composition and then photo-curing the sheet. Examples of the fiber forming the cloth or nonwoven fabric include an inorganic fiber such as glass fiber, alumina fiber, carbon fiber, alumina-silica fiber, boron fiber, high silicon fiber, potassium titanate fiber and sapphire fiber; a natural fiber such as cotton and hemp; a semisynthetic fiber such as rayon and acetate; and a synthetic fiber such as nylon, polyester, acryl, vinylon, polyvinyl chloride, polyolefin, polyurethane, polyimide and aramid. In addition, cellulose produced by a bacterium is a high crystalline nanofiber and is a material capable of producing a thin nonwoven fabric having high dimensional stability.

From the standpoint of enhancing the strength of the film formed, the laser-decomposable resin composition of the present invention is preferably cured by crosslinking (polymerization) before decomposition with a laser. For curing the composition, the above-described polymerizable compound is preferably contained in the composition. This is generally employed as means for increasing the film strength in the field of negative (polymerization-type) photosensitive material and is considered to have the same effect also in the present invention. This method is effective particularly when the pattern-forming material is a laser-engravable flexographic printing plate precursor. Curing the resin composition before laser engraving is advantageous in that the relief formed after laser engraving becomes sharp and the viscous property of engraving debris generated during laser engraving is reduced.

As regards the method for curing the composition, any means can be used without particular limitation as long as it causes a polymerization reaction of the polymerizable compound in the composition, for example, light may be irradiated, or a photo- or thermo-polymerization initiator or the like may be added to the composition and irradiated with light or heated.

Above all, in view of simple operation, heating of the composition is preferred as the method for curing. All heating methods such as oven, thermal head, heated roll and laser beam can be applied to the heating for causing crosslinking (polymerization) in the composition before laser decomposition. In the case where the temperature needs to be controlled, this can be attained by controlling the temperature of oven, thermal head, heated roll or the like, or adjusting the intensity or spot size of laser beam. In view of thermal stability of the organic compound present together, the heating temperature is preferably from 40 to 250°C, more preferably from 60 to 220°C, still more preferably from 80 to 200°C. The heating time is preferably from 1 to 120 minutes, more preferably from 5 to 60 minutes, because a side reaction (e.g., thermal decomposition of additive) except for curing is not caused by the heating.

The thickness of the pattern-forming layer is generally from 0.0005 to 10 mm, preferably from 0.005 to 7 mm.

In the case of use for laser engraving, the thickness may be arbitrarily selected according to the intended use but is preferably from 0.05 to 10 mm, more preferably from 0.1 to 7 mm.

Depending on the case, a plurality of layers differing in the composition may be stacked.

As regards the combination comprising a plurality of layers, for example, a layer which can be engraved with a laser having an emission wavelength in the near infrared region, such as YAG laser, fiber laser and semiconductor laser, may be formed as the outermost surface layer, and a layer which can be laser-engraved with an infrared laser such as carbon dioxide gas laser or with a visible-ultraviolet laser may be formed below the outermost surface layer. In the case of laser-engraving these layers, the engraving can be performed using different laser engraving devices where an infrared laser is mounted in one device and a near infrared laser is mounted in another device, or using a laser engraving device on which both an infrared laser and a near infrared laser are mounted.

In the case where the pattern-forming layer comprises a plurality of layers, the thickness of the pattern-forming layer (the sum of lower and upper layers) is generally from 0.0005 to 10 mm, preferably from 0.005 to 7 mm.

In view of pattern formation with ease (with high sensitivity), the lower layer/upper layer ratio in the above-described thickness is preferably from 30/70 to 95/5, more preferably from 50/50 to 95/5, still more preferably from 70/30 to 90/10.

In the case of stacking a plurality of layers, the pattern-forming layer of the present invention is preferably formed, for example, by a method of once dissolving the components of each layer in a solvent, coating and drying the lower layer on a support, and then coating and drying the upper layer, or a method of kneading the components of each layer in a kneader and sequentially casting the layers on a support.

In the present invention, a cushion layer comprising a resin or rubber having cushioning property can be formed between the support and the pattern-forming layer or between the pattern-forming layer and the adhesive layer. In the case of forming a cushion layer between the support and the pattern-forming layer, a method of laminating a cushion layer having on one side thereof an adhesive layer while arranging the adhesive layer side toward the support is simple. After laminating the cushion layer, the surface may be shaped through cutting and polishing. In a simpler method, a liquid adhesive composition is coated on the support to a constant thickness and cured with light to form the cushion layer. For ensuring the cushioning property, the cured product after photo-curing preferably has low hardness. The photosensitive resin cured layer having the cushioning property may contain bubbles.

### <Laser Engraving>

In the laser engraving, a relief image is formed on the pattern-forming material by creating digitized data of an image intended to form and operating a laser device by means of a computer.

As described above, the pattern-forming material for use in the laser engraving is not particularly limited, but above all, a laser-engravable flexographic printing plate precursor is preferred.

The laser used in the laser engraving may be any laser as long as the pattern-forming material can form a pattern by laser ablation, but in order to perform the engraving at a high speed, a high-power laser is preferred. One preferred example thereof is a laser having an emission wavelength in the infrared or near infrared region, such as carbon dioxide gas laser, YAG laser, semiconductor laser and fiber laser. Also, an ultraviolet laser having an emission wavelength in the ultraviolet region, such as excimer laser, YAG laser wavelength-converted to the third or fourth harmonic and copper vapor laser, can effect the ablation processing of breaking a molecular bond of an organic compound and is suitable for microfabrication. A laser having an extremely high peak power, such as femtosecond laser, can also be used. The laser irradiation may be either continuous irradiation or pulsed irradiation. For the laser-engravable flexographic printing plate precursor, a carbon dioxide gas laser and a YAG laser are preferably used.

The engraving with a laser is performed under an oxygen-containing gas, generally in the presence of air or in airflow, but may also be performed under a carbon dioxide gas or a nitrogen gas. After the completion of engraving, the powdery or liquid substance (debris) generated on the relief image surface can be removed by an appropriate method, for example, a method of washing it out with a solvent or a surfactant-containing water, a method of spraying an aqueous cleaning agent by means of a high-pressure sprayer, a method of spraying high-pressure steam, or a method of wiping it off with cloth or the like.

The resin composition of the present invention can be applied not only to the relief image but also to various uses such as stamp/seal, design roll for embossing, relief image for patterning an insulator, resistor or electrical conductor paste used for the production of electronic components, relief image for the mold material of ceramic products, relief image for display (e.g., advertising board, sign board), and prototype/matrix of various molded articles.

Furthermore, tackiness on the surface can be reduced by forming a modifying layer on the pattern image surface after laser engraving. Examples of the modifying layer include a coating treated with a compound which reacts with the hydroxy group on the pattern image surface, such as silane coupling agent and titanium coupling agent, and a polymer film containing porous inorganic particles. The silane coupling agent widely used is a compound having in its molecule a functional group highly reactive with the hydroxy group on the pattern image surface, and examples of the functional group include a trimethoxysilyl group, a triethoxysilyl group, a trichlorosilyl group, a diethoxysilyl group, a dimethoxysilyl group, a dichlorosilyl group, a monoethoxysilyl group, a monomethoxysilyl group and a monochlorosilyl group. At least one of these functional groups is present in the molecule and reacts with the hydroxyl group on the pattern image surface, whereby the compound is fixed on the surface. As regards the compound constituting the silane coupling agent for use in the present invention, those having in the molecule thereof at least one reactive functional group selected from an acryloyl group, a methacryloyl group, an active halogen-containing amino group, an epoxy group, a vinyl group, a perfluoroalkyl group and a mercapto group, or having a long chain alkyl group may be used. Particularly, in the case where the molecule of the coupling agent fixed on the surface has a polymerizable reactive group, crosslinking occurs when the surface after fixing is irradiated with light, heat or electron beam, and a firmer coating can be thereby formed.

### [Examples]

The present invention is described in greater detail below by referring to Examples, but the present invention should not be construed as being limited to these

### Examples.

### [Examples 1 to 10 and Comparative Examples 1 to 3]

### <Evaluation of Thermophysical Properties>

Compounds C-1 to C-9 as the component (A) used in Examples are shown below.
C-1: Fullerene C60
C-2: Fullerene C70
C-3: Single-wall carbon nanotube (SWNT) (produced by Wako Pure Chemical Industries, Ltd.)
C-4: Multi-wall carbon nanotube (MWNT) (produced by Wako Pure Chemical Industries, Ltd.)
C-5: SWNT subjected to cutting treatment
C-6: SWNT of which surface is modified with an amino group
C-7: SWNT physically modified with schizophyllan
C-8: SWNT physically modified with curdlan
C-9: SWNT physically modified with curdlan which is reduced in the molecular weight

The carbon nanotubes used in these Examples preferably have a tube length of 5 to 8,000 nm more preferably from 10 to 5,000 nm, still more preferably from 15 to 1,000 nm, and most preferably from 20 to 1,000 nm, because the physical modification is effectively performed. Also, carbon nanotubes (may be either a single-wall carbon nanotube or a multi-wall carbon nanotube) having various lengths, which are commercially available from Aldrich, Wako Pure Chemical Industries, Ltd. and Tokyo Kasei Kogyo Co., Ltd., may be used. The tube length can be easily known by the observation through a transmission electron microscope (TEM) or an atomic force microscope (AFM).

### <Synthesis of C-5>

In a 50 ml-volume measuring flask, an uncut single-wall carbon nanotube (SWNT (produced by Wako Pure Chemical Industries, Ltd.)) (10 mg) and a 3:1 (v/v) solution of sulfuric acid : nitric acid (50 ml, (37.5 ml of 98% sulfuric acid) + (12.5 ml of 60% nitric acid)) were added and ultrasonically treated for 2 hours. At this time, in order to prevent the apparatus from taking on heat, ice was filled in the bath. Also, the flask was well shaken by hand every 10 minutes for making the SWNT length uniform. After confirming that the dispersion solution became uniform, the dispersion solution was added to ice water (300 ml). The cut SWNT collected by filtration using a membrane filter (PTFE, 0.2 mm) wetted with ethanol was washed with an aqueous 10 mM sodium hydroxide solution (10 ml) and ultrapure water (20 ml). The obtained sample was dispersed in ultrapure water (20 ml) and ultrasonically treated for 1 minute. This dispersion solution was subjected to an operation of removing the precipitate by centrifugal separation (2,000 G) for 10 minutes, whereby SWNT of 3 µm or more was removed. Furthermore, the extracted supernatant was subjected to an operation of removing the supernatant by high-speed centrifugal separation (17,500 G) for 1 hour, whereby SWNT of 1 µm or less was removed. This operation was repeated three times, and the finally obtained precipitate was dispersed in ultrapure water (20 ml), ultrasonically treated for 15 minutes and then subjected to an operation of removing the precipitate by centrifugal operation (3,500 G) for 10 minutes. The obtained cut SWNT was observed through AFM and confirmed to have a length of 1 to 3 µm. At the measurement, the carbon nanotube was used after again performing an ultrasonic treatment for 15 minutes and an operation by centrifugal separation (3,500 G) for 10 minutes. The yield of C-5 obtained was 1.6 mg.

### <Synthesis of C-6>

A single-wall carbon nanotube (AP-SWCNT, single-wall carbon nanotube produced by Carbolex) (150 mg) produced by an arc discharge method was heat-treated at 350°C for 18 hours and ultrasonically dispersed in hydrochloric acid (100 mL, 36%) at room temperature. The obtained dispersion was ultrasonically treated at room temperature in order in a mixed solution of sulfuric acid (5 mL, 97%) and nitric acid (18 mL, 70%) and in a mixed solution of sulfuric acid (48 mL, 97%) and hydrogen peroxide (12 mL, 30%). Furthermore, 9.5 mg of SWNT was dispersed in dimethylformamide (20 mL) and after adding octadecylamine (1 g) and dicyclohexylcarbodiimide (DCC) 0.5 g), the reaction was allowed to proceed at 120°C for 60 hours, thereby synthesizing a soluble single-wall carbon nanotube. Yield: 75%, purity of compound produced: 97%. The objective was identified by the visible near infrared absorption spectrum, Raman spectrum and AFM observation.

### <Synthesis of C-7>

In a 300 ml-volume Kjeldahl flask, 5 g of schizophyllan (weight average molecular weight: about 100,000) was dissolved in 80 g of dimethylsulfoxide with stirring under heating at 60°C (Solution A). Separately, 3 g of single-wall SWNT (produced by Wako Pure Chemical Industries, Ltd.) and 20 g of distilled water were charged into a 50 ml-volume sample vial and irradiated with an ultrasonic wave at room temperature for 60 minutes (Solution B). Solution B was gently poured in Solution A under stirring at room temperature, and the resulting solution was stirred for 1 hour. Thereafter, this solution was charged into 500 ml of methyl ethyl ketone to precipitate the objective and after filtration and drying under reduced pressure at room temperature for 2 days, C-7 was obtained. It was confirmed by observation through a transmission electron microscope (TEM) and an atomic force microscope (AFM) that SWNT was physically modified and converted into C-7.

C-8 was synthesized by the same operation as that for C-7 except that schizophyllan was changed to curdlan (weight average molecular weight: 1,000,000 or more, produced by Wako Pure Chemical Industries, Ltd.).

### <Synthesis of C-9>

Curdlan (weight average molecular weight: 1,000,000, produced by Wako Pure Chemical Industries, Ltd.) (5 g) was mixed with 900 ml of dimethylsulfoxide (DMSO), and schizophyllan was dispersed therein with stirring overnight at 60°C. For the stirring, a three-one motor was used and the rotation speed was set to 400 rpm. Also, the reaction was performed under a nitrogen stream. Subsequently, 9.5 g of p-toluene sulfonic acid and 10 ml of water were added at 60°C, and the resulting solution was stirred and after elevating the oil bath temperature to 93°C, further stirred under heating for 20 days. The obtained DMSO solution was dialyzed (using Spectropore produced by Funakoshi Corp., which is organic solvent resistant) with distilled water to obtain molecular weight-reduced curdlan (weight average molecular weight: 30,000). Reduction in the molecular weight of curdlan was confirmed by gel permeation chromatography (GPC).

Using this molecular weight-reduced curdlan, single-wall SWNT (produced by Wako Pure Chemical Industries, Ltd.) was physically modified through the same procedure as that for C-8. It was confirmed by the observation through a transmission electron microscope (TEM) and an atomic force microscope (AFM) that SWNT was physically modified with molecular weight-reduced curdlan and converted into C-9.

### <Measurement of Thermophysical Properties>

### <Production of Polymer Composition Sample for Evaluation of Polymer Physical Properties>

In 100 ml of tetrahydrofuran, 8.5 g of a binder polymer (TR2000, trade name (produced by JSR), a styrene-butadiene copolymer) and 1.5 g of the specific compound prepared above (C-1 to C-9) or the compound shown in Table 1 for use in Comparative Example were heated and stirred at 60°C for 1 hour. The resulting solution was poured in a glass-made Petri dish, and tetrahydrofuran was naturally evaporated to obtain a composition sample.
If desired, the solution was irradiated with an ultrasonic wave (at room temperature for 15 minutes) before the heating and stirring at 60°C for 1 hour.
The thermal decomposition initiating temperature was measured under the following conditions. The term "thermal decomposition initiating temperature" as used herein is a temperature at which decrease in the mass ascribable to thermal decomposition of the sample initiates as the sample is heated.

### <Instrument>

Thermal mass measuring apparatus (manufactured by TA Instruments, Japan)

### <Measurement Conditions>

The composition sample was weighed (10 mg) and heated to 500°C from 30°C at a temperature rising rate of 10°C/min.

The results are shown in Table 1.

**Table 1: Evaluation Results of Thermal Decomposability**

| Example No. | Specific Carbon Nanotube or Fullerene | Presence or Absence of Ultrasonic Irradiation | Thermal Decomposition Initiating Temperature of Sample (°C) |
|---|---|---|---|
| 1 | C-1 | irradiated | 350 |
| 2 | C-2 | irradiated | 352 |
| 3 | C-3 | none | 340 |
| 4 | C-3 | irradiated | 320 |
| 5 | C-4 | irradiated | 320 |
| 6 | C-5 | irradiated | 310 |
| 7 | C-6 | irradiated | 310 |
| 8 | C-7 | irradiated | 295 |
| 9 | C-8 | irradiated | 283 |
| 10 | C-9 | irradiated | 270 |

| Comparative Example No. | | | |
|---|---|---|---|
| 1 | none | irradiated | 412 |
| 2 | carbon black | irradiated | 385 |
| 3 | graphite | irradiated | 390 |

It is seen from Table 1 that in Examples, the thermal decomposition initiating temperature is decreased in all samples as compared with Comparative Examples and the thermal decomposability is excellent. This result reveals that the binder polymer is more enhanced in the thermal decomposability by the action of a carbon nanotube or a fullerene.

### [Examples 11 to 17 and Comparative Examples 4 to 6]

### <Evaluation of Laser Decomposability>

The depth to which a film comprising the composition of the present invention was engraved, was used as the index for laser decomposability. When a laser was irradiated with the same energy, as the film is engraved more deeply, this means that the laser decomposability is higher.

**Table 2: Construction of Relief Layer**

| Components of Relief Layer | Starting Material | Amount (wt%) |
|---|---|---|
| Binder polymer | TR2000, trade name (produced by JSR) | 85.00 |
| Polymerizable compound | hexanediol dimethacrylate lauryl acrylate | 5 5 |
| Specific carbon nanotube or fullerene | see Table 3 | 5.00 |

In forming the relief layer shown in Table 2 on a support, the binder polymer, carbon nanotube or fullerene (in Comparative Example, carbon black), and initiator were mixed in a laboratory kneader at a material temperature of 100°C. After 30 minutes, the carbon nanotube or fullerene or the carbon black used in Comparative Example was uniformly dispersed. Subsequently, the mixture obtained was dissolved together with the polymerizable compound (monomer) in toluene at 100°C, irradiated, if desired, with an ultrasonic wave (at room temperature for 15 minutes), cooled to 40°C, cast on an uncoated 125 µm-thick PET film, dried in air at room temperature for 48 hours, and further dried at 90°C for 1.5 hours. The obtained relief layer (thickness: 1,000 µm) was laminated (stacked) on a second 125 µm-thick PET film coated with a mixture of adhesive layer-forming components, and the uncoated 125 µm-thick PET film was stripped off to prepare a sample.

In the test for evaluating the laser engraving depth, 30 squares of 1 cm x 1 cm were engraved using "High-Grade CO₂ Laser Marker ML-9100 Series (produced by KEYENCE Corp.)" at 12 W and a line speed of 10 cm/sec in the case of a carbonic acid (CO₂) laser, and using "MARKER ENGINE 3000 (produced by Laserfront Technologies, Inc.)" at 10 W and a line speed of 10 cm/sec in the case of an Nd-YAG laser. With respect to the sensitivity to laser decomposition, the engraving depth was measured using a high-speed high-precision CCD laser displacement meter, LK-G35, produced by KEYENCE Corp. Engraved 30 squares all were measured, and an average value thereof was employed.

### <Evaluation of Sensitivity Unevenness>

The engraving depth was measured using a high-speed high-precision CCD laser displacement meter, LK-G35, produced by KEYENCE Corp. as described above with respect to the sensitivity to laser decomposition. Engraved 30 squares all were measured, and the standard deviation thereof was employed as the index for fluctuation in the engraving depth (sensitivity unevenness). A larger standard deviation indicates larger fluctuation in the engraving depth (sensitivity unevenness).

The results are shown in Table 3.

**Table 3: Evaluation Results of Engraving Depth**

| Example No. | Specific Carbon Nanotube or Fullerene | Presence or Absence of Ultrasonic Irradiation | Kind of Laser | Engraving Depth (µm) | Standard Deviation of Engraving Depth |
|---|---|---|---|---|---|
| 11 | C-1 | irradiated | CO₂ | 280 | 35 |
| 12 | C-3 | none | CO₂ | 290 | 34 |
| 13 | C-3 | irradiated | CO₂ | 310 | 25 |
| 14 | C-5 | irradiated | CO₂ | 330 | 18 |
| 15 | C-8 | irradiated | CO₂ | 352 | 11 |
| 16 | C-9 | irradiated | CO₂ | 380 | 8 |
| 17 | C-9 | irradiated | Nd-YAG | 130 | 9 |
| Comparative Example | | | | | |
| 4 | Carbon black | irradiated | CO₂ | 115 | 40 |
| 5 | none | irradiated | CO₂ | 100 | 8 |
| 6 | Carbon black | irradiated | Nd-YAG | 40 | 19 |

As seen from Table 3, in the case of the specific carbon nanotube or fullerene which enhanced the thermal decomposability of polymer in Table 1, the engraving depth was increased by virtue of the enhancement effect in the thermal decomposability as compared with carbon black or no addition. Also, in the case of carbon nanotube subjected to cutting treatment, chemical modification or physical modification, the standard deviation of engraving depth was decreased. That is, the laser decomposability was enhanced and an effect of reducing the sensitivity unevenness was observed.

According to the present invention, a laser-decomposable resin composition which is applicable also to a thick film, exhibits high engraving sensitivity and enables efficient engraving with a low laser energy, and a pattern-forming material and a laser-engravable flexographic printing plate precursor, each using the composition, are provided.

The entire disclosure of each and every foreign patent application from which the benefit of foreign priority has been claimed in the present application is incorporated herein by reference, as if fully set forth.

## Claims

1. A laser-decomposable resin composition comprising:
(A) at least one selected from the group consisting of a carbon nanotube and a fullerene; and
(B) a binder polymer.

2. The laser-decomposable resin composition according to claim 1, wherein
the component (A) is a carbon nanotube.

3. The laser-decomposable resin composition according to claim 2, wherein
the carbon nanotube is a carbon nanotube subjected to at least one of chemical modification and physical modification.

4. The laser-decomposable resin composition according to claim 2, wherein
the carbon nanotube is a carbon nanotube subjected to ultrasonic irradiation.

5. The laser-decomposable resin composition according to claim 2, wherein
the carbon nanotube has a length of from 20 nm to 10 µm.

6. The laser-decomposable resin composition according to claim 2, wherein
the carbon nanotube is a carbon nanotube physically modified by interaction with a polymer different from the component (B).

7. The laser-decomposable resin composition according to claim 6, wherein
the polymer different from the component (B) is a polysaccharide.

8. The laser-decomposable resin composition according to claim 1, wherein
the component (A) is an unmodified fullerene.

9. The laser-decomposable resin composition according to claim 1, further comprising:
(C) a polymerizable compound.

10. A laser-decomposable resin composition obtained by curing the laser-decomposable resin composition according to claim 1.

11. A pattern-forming material comprising:
a layer that comprises the laser-decomposable resin composition according to claim 1.

12. A laser-engravable flexographic printing plate precursor comprising:
the pattern-forming material according to claim 11.
